# EUROPEAN PATENT SPECIFICATION

(11) **EP 0 924 724 B1**
(45) Date of publication and mention of the grant of the patent: **13.08.2003**
(21) Application number: 98122973.5
(22) Date of filing: 03.12.1998
(51) Int. Cl.: H01G 9/20

(54) **Photoelectric conversion device and photo-electrochemical cell**
Photoelektrische Umwandlungsvorrichtung und photoelektrochemische Zelle
Dispositif de conversion photoélectrique et cellule photo-électrochimique

(30) Priority: 16.12.1997 JP 36350397
(43) Date of publication of application: 23.06.1999
(73) Proprietor: FUJI PHOTO FILM CO., LTD., Kanagawa 250-01 (JP)
(72) Inventor: Shiratsuchi, Kentaro, Minami-ashigara-shi, Kanagawa (JP); Yanagida, Shozo, Kawanishi-shi, Hyogo (JP); Shirai, Hirofusa, Chiisagata-gun, Nagano (JP); Hanabusa, Kenji, Ueda-shi, Nagano (JP)
(74) Representative: Patentanwälte Dr. Solf & Zapf

(56) References cited:
- WO-A-97/08719
- DE-A- 4 327 114
- DE-U- 9 312 084
- CAO F ET AL: "A SOLID STATE, DYE SENSITIZED PHOTOELECTROCHEMICAL CELL" JOURNAL OF PHYSICAL CHEMISTRY, AMERICAN CHEMICAL SOCIETY, US, vol. 99, no. 47, 1995, pages 17071-17073, XP000933431 ISSN: 0022-3654
- HANABUSA K ET AL: "Excellent Gelators for Organic Fluids: Simple Bolaform Amides Derived from Amino Acids" ADVANCED MATERIALS, VCH VERLAGSGESELLSCHAFT, WEINHEIM, DE, vol. 9, no. 14, 14 November 1997 (1997-11-14), pages 1095-1097, XP000724218 ISSN: 0935-9648
- YIH-CHYUAN LIN ET AL: "Novel family of gelators of organic fluids and the structure of their gels" JOURNAL OF THE AMERICAN CHEMICAL SOCIETY, 19 JULY 1989, USA, vol. 111, no. 15, pages 5542-5551, XP001016111 ISSN: 0002-7863

## Description

This invention relates to a photoelectric converter, and more particularly, to a photoelectric converter comprising a dye-sensitized nanoparticulate semiconductor. It also relates to a photo-electrochemical cell.

### BACKGROUND OF THE INVENTION

With respect to the solar power generation, monocrystalline silicon solar batteries, polycrystalline silicon solar batteries, amorphous solar batteries, and compound solar batteries using cadmium telluride or indium copper selenide have been used in practice or become the major object of research and development. For the widespread use, problems including the manufacturing cost, the availability of source materials, and a long energy payback time must be solved. On the other hand, many solar batteries using organic materials intended for increasing the surface area and lowering the cost have also been proposed, but they have the drawbacks of low efficiency conversion and poor durability.

Under the circumstances, Nature, Vol. 353, pp. 737-470, 1991, and USP 4,927,721, for example, disclose photoelectric converters comprising dye-sensitized microparticulate semiconductors (to be referred to as dye-sensitized photoelectric converter, hereinafter) as well as materials and processes for use in the manufacture of these converters. The device proposed in these patents is a wet solar battery having as a working electrode a porous titanium dioxide thin film spectrally sensitized with a ruthenium complex. This system has the advantages of a low cost and highly efficient energy conversion. However, since an electrolyte solution is used in the hole transporting layer, long-term operation causes the depletion of the electrolytic solution and hence, a substantial drop of photoelectric conversion efficiency so that the device may not exert its own function. As a solution to these drawbacks, International Patent No. 93/20565 proposes a photoelectric converter using a solid electrolyte, JP-A 288142/1995, Solid State Ionics, 89 (1996), 263, and JP-A 27352/1997 propose a photoelectric converter using crosslinked polyethylene oxide solid polymer electrolyte for solidification. However, a study on the photoelectric converters using these solid electrolytes revealed that they are still insufficient in photoelectric conversion characteristics, especially short-circuit current density.

In Journal of Physical chemistry 99, no. 47, 1995, pages 17071-17073, there is disclosed a photoelectrochemical cell comprising a conductive glass support, a layer of dye coated TiO₂ nanoparticles coated thereon, a gel electrolyte containing layer and a Pt coated counter electrode. The gel electrolyte contains an electrolyte, an organic solvent, and a polyacrylonitrile gel.

### SUMMARY OF THE INVENTION

An object of the present invention is to provide a dye-sensitized photoelectric converter having improved photoelectric conversion characteristics and durability. Another object of the present invention is to provide a photo-regenerative photo-electrochemical cell using the same.

The invention provides a photoelectric conversion device comprising a conductive support, a layer coated on the conductive support and containing semiconductor nanoparticulates having a dye adsorbed thereto, a gel electrolyte-containing layer, and a counter electrode. According to the invention, the gel electrolyte contains an electrolyte,an organic solvent, and a gelling agent having a molecular weight of up to 1,000 by which gelling of said gel electrolyte is caused.

In one preferred embodiment, the electrolyte comprises a metal iodide, iodide salt of quaternary ammonium compound, iodide salt of quaternary imidazolium compound, iodide salt of quaternary pyridinium compound, metal bromide, bromide salt of quaternary ammonium compound, sulfur compound, viologen dye, or hydroquinone-quinone. The electrolyte may contain iodine. The electrolyte is preferably present in a concentration of 0.05 to 1.5 mol/liter of the gel electrolyte. The gelling agent is preferably present in a concentration of 0.2 to 500 g/liter of the gel electrolyte. The gel electrolyte further contains at least one organic solvent which may be selected from among nitrile compounds, carbonate compounds, nitrogenous heterocyclic compounds, and ethylene glycol dialkyl ethers.

The dye is typically a ruthenium complex dye or polymethine dye.

Also contemplated herein is a photo-electrochemical cell comprising the photoelectric conversion device.

### BRIEF DESCRIPTION OF THE DRAWINGS

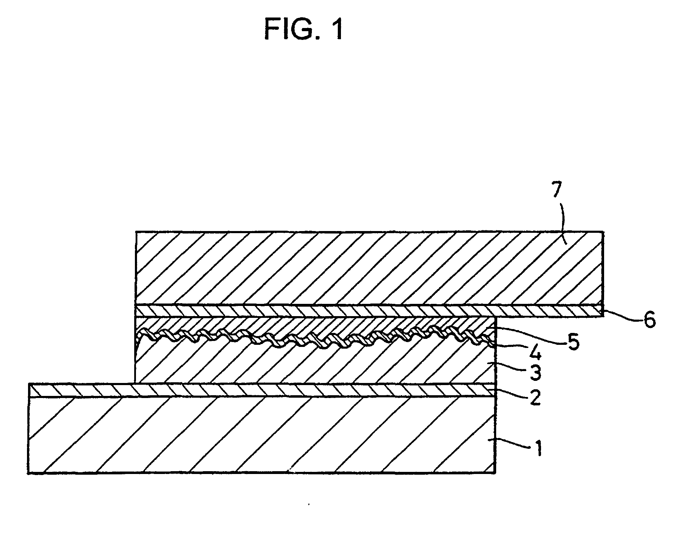

The only figure, FIG. 1 is a diagrammatic sectional view showing the layer structure of a photo-electrochemical cell constructed in Example.

### BEST MODE FOR CARRYING OUT THE INVENTION

According to the invention, the dye-sensitized photoelectric converter device is defined as comprising a conductive support, a layer coated on the conductive support and containing semiconductor nanoparticulates having a dye adsorbed thereto, which is also referred to as a photosensitive layer, a gel electrolyte-containing layer, and a counter electrode. The gel electrolyte contains an electrolyte and a gelling agent having a molecular weight of up to 1,000. The gelling agent used herein is a compound which when added to an organic solvent in a concentration of up to 500 g/liter, can solidify or gel the entire system.

Incorporation of the gelling agent having a molecular weight of up to 1,000 into the gel electrolyte-containing layer ensures the manufacture of a photoelectric converter device having improved photoelectric conversion characteristics and durability as demonstrated by a high short-circuit current density and no degradation with time of short-circuit current density. In contrast, use of an electrolyte solution instead of the gel electrolyte invites a substantial degradation with time; and use of an electrolyte comprising as a matrix a crosslinked polymeric gel in which a crosslinking agent serves as a gelling agent results in a low short-circuit current density.

The conductive supports used herein include metal supports which have conductivity in themselves and glass or plastic supports having a conductive agent layer on their surface. In the latter case, preferred conductive agents are metals such as platinum, gold, silver, copper, aluminum, rhodium, and indium, carbon, and conductive metal oxides such as indium-tin composite oxides and fluorine-doped tin oxide. Especially preferred are conductive glass supports in the form of transparent substrates of low cost sodalime float glass having deposited thereon a conductive layer of fluorine-doped tin dioxide. The conductive layer preferably has a thickness of about 0.02 to about 10 µm.

It is recommended that the conductive supports have a lower surface resistivity. The preferred range of surface resistivity is up to 100 Ω/cm², more preferably up to 40 Ω/cm². The lower limit of the surface resistivity is not critical although it is usually about 0.1 Ω/cm².

It is also recommended that the conductive supports be substantially transparent. The term "substantially transparent" means that the light transmittance of the support is at least 10%, preferably at least 50%, more preferably at least 70%. As the transparent conductive support, glass or plastic supports having conductive metal oxide coated thereon are preferable. The coverage or weight of conductive metal oxide coated is preferably 0.01 to 100 g per square meter of the glass or plastic support. Where transparent conductive supports are used, it is desired that light enter the device from the support side.

In the photosensitive layer, nanoparticulates of metal chalcogenides (e.g., oxides, sulfides and selenides) or perovskite may be used as the nanoparticulate semiconductor. Examples of the metal chalcogenides include oxides of titanium, tin, zinc, tungsten, zirconium, hafnium, strontium, indium, cerium, yttrium, lanthanum, vanadium, niobium, and tantalum, cadmium sulfide, and cadmium selenide. Preferred examples of the perovskite are strontium titanate and calcium titanate. Of these, titanium oxide, zinc oxide, tin oxide and tungsten oxide are especially preferred.

The semiconductor nanoparticulates preferably have a mean particle size of 5 to 200 nm, more preferably 8 to 100 nm, expressed by the diameter of a circle of equivalent area to the projected area of a primary particle. Also preferably, the semiconductor particles in the dispersion have a mean particle size of 0.01 to 100 µm.

Various methods are employable for coating semiconductor nanoparticulates to a conductive support. Exemplary methods are a method of applying a dispersion liquid or colloid solution of semiconductor nanoparticulates onto a conductive support, and a method (known as sol-gel method) of applying a semiconductor nanoparticulate precursor onto a conductive support and allowing the precursor to be hydrolyzed with moisture in air and condensed, thereby forming a semiconductor nanoparticulate coating. The dispersion liquid of semiconductor nanoparticulates can be prepared by the sol-gel method and other methods such as grinding in a mortar, milling and dispersing in a mill, and synthesizing a semiconductor under such conditions that the semiconductor may precipitate in a solvent as nanoparticulates. The dispersing media may be water or various organic solvents such as methanol, ethanol, isopropanol, dichloromethane, acetone, acetonitrile, and ethyl acetate. In forming a dispersion, polymers, surfactants, acids or chelates may be used as the dispersant if necessary.

Semiconductor nanoparticulates are desired to have a greater surface area so that more dye may be adsorbed thereon. The semiconductor nanoparticulates as applied onto the support to form a layer should preferably have a surface area which is greater than the projected area by a factor of at least 10, more preferably at least 100. No upper limit is imposed on the surface area although the upper limit is usually a multiplication factor of about 1,000.

In general, as the semiconductor nanoparticulate layer becomes thicker, the amount of the dye carried per unit projected area increases so that the capture rate of light becomes higher, but the loss by charge recombination becomes greater because the diffusion distance of generated electrons increases. For this reason, the semiconductor nanoparticulate layer has an appropriate range of thickness which is typically 0.1 to 100 µm. When the semiconductor nanoparticulate layer is used in a photo-regenerative photo-electrochemical cell, an appropriate thickness is 1 to 30 µm, especially 3 to 20 µm. After coating on a support, semiconductor nanoparticulates may be fired in order to bring the particulates into electronic contact and improve the strength and the adhesion to the support of the coating. The preferred range of firing temperature is from 40°C to less than 700°C, more preferably 40°C to 650°C. The firing time is about 10 minutes to about 10 hours.

Further, after firing, the semiconductor nanoparticulates may be subject to chemical plating in an aqueous solution of titanium tetrachloride or electrochemical plating in an aqueous solution of titanium trichloride, for the purpose of increasing the surface area of semiconductor nanoparticulates or increasing the purity in the vicinity of semiconductor nanoparticulates for increasing the efficiency of electron injection from the dye into the semiconductor nanoparticulates.

The coverage or weight of semiconductor nanoparticulates coated is preferably 0.5 to 500 g, more preferably 2 to 100 g per square meter of the support.

The dyes, also called chromophores or sensitizers, which are used in the present invention are preferably ruthenium complex dyes and/or polymethine dyes. Further preferably, the dyes have appropriate interlocking groups to surfaces of semiconductor nanoparticulates. Preferred interlocking groups include COOH, cyano, and PO₃H₂ groups, as well as chelating groups having π-conducting character such as oximes, dioximes, hydroxyquinolines, salicylates, and alpha-keto enolates. Of these, COOH and PO₃H₂ groups are especially preferred. These groups may form salts with alkali metals or intramolecular salts.

Where ruthenium complex dyes are used in the practice of the invention, they are preferably of the following general formula (1).

(1) (Xa)ₙₐRu(L₁) (L₁ₐ)

In formula (1), Ru is ruthenium, Xa is a ligand selected from the group consisting of Cl, SCN, H₂O, Br, I, CN, -NCO, and SeCN, letter na is equal to 1 or 2, preferably equal to 2, L₁ and L₁ₐ each are an organic ligand selected from the following ligands L-1 to L-9.

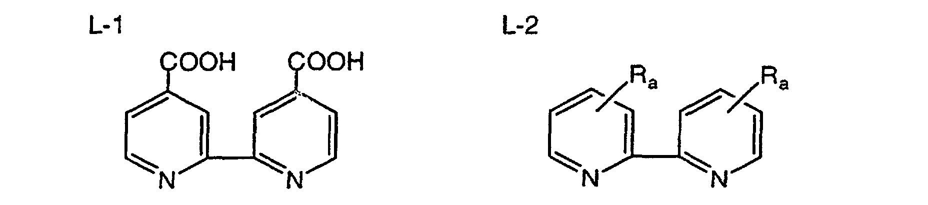

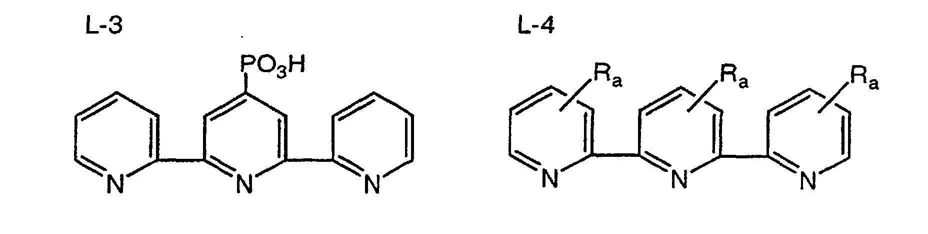

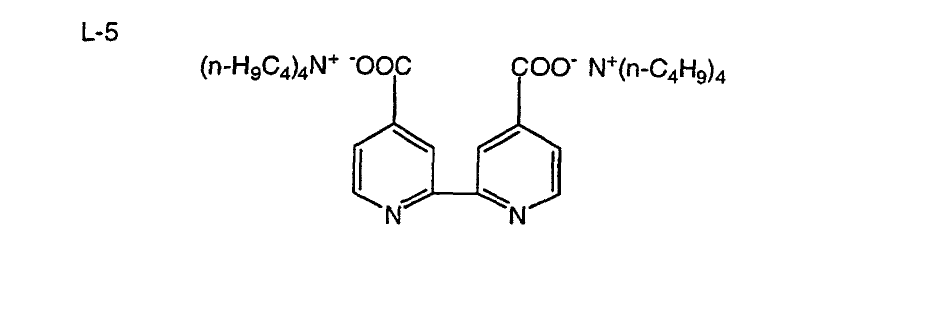

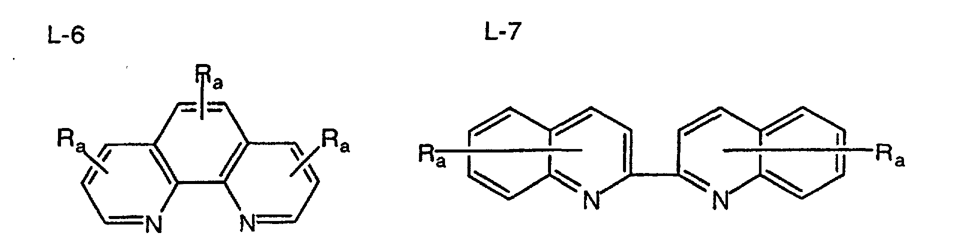

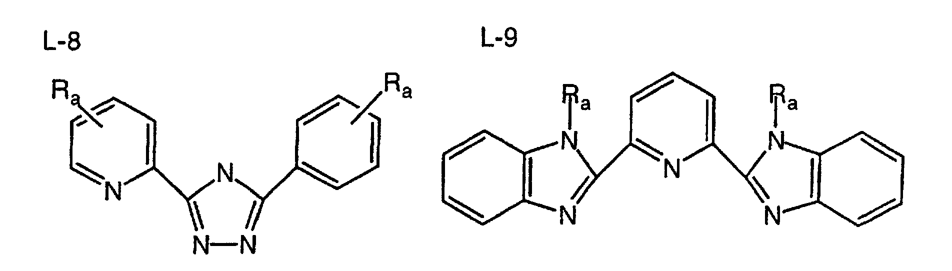

In the formulae, Ra is hydrogen, a halogen atom or a substituted or unsubstituted alkyl, aralkyl or aryl group having 1 to 12 carbon atoms.

The ruthenium complex dyes which can be used herein are, for example, the complex dyes described in USP 4,927,721, 4,684,537, 5,084,365, 5,350,644, 5,463,057, 5,525,440 and JP-A 249790/1995.

Preferred illustrative, non-limiting, examples of the ruthenium complex dyes which can be used herein are given below.

**Table 1**

| No. | Xa | na | L1 | L1a |
|---|---|---|---|---|
| R-1 | SCN | 2 | L-1 | L-1 |
| R-2 | CN | 2 | L-1 | L-1 |
| R-3 | Cl | 2 | L-1 | L-1 |
| R-4 | Br | 2 | L-1 | L-1 |
| R-5 | I | 2 | L-1 | L-1 |
| R-6 | SCN | 2 | L-1 | L-5 |
| R-7 | SCN | 1 | L-1 | L-3 |
| R-8 | Cl | 1 | L-1 | L-4 |
| R-9 | I | 2 | L-1 | L-6 |
| R-10 | SCN | 2 | L-1 | L-7 |
| R-11 | CN | 2 | L-1 | L-8 |
| R-12 | Cl | 1 | L-1 | L-9 |
| Note that all Ra's are hydrogen. | | | | |

Where polymethine dyes are used in the practice of the invention, they are preferably of the following general formula (2) or (3).

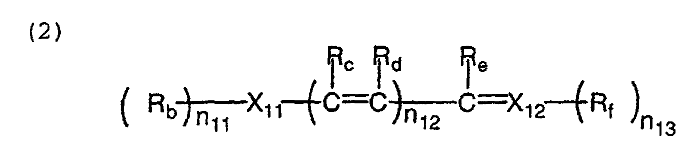

In formula (2), Rb and Rf are independently hydrogen, alkyl groups, aryl groups or heterocyclic residues, Rc to Re are independently hydrogen or substituents. Alternatively, Rb to Rf, taken together, may form a ring. X₁₁ and X₁₂ are independently nitrogen, oxygen, sulfur, selenium or tellurium. Letters n₁₁ and n₁₃ are integers of 0 to 2, and n₁₂ is an integer of 1 to 6. The compound of formula (2) may have a counter ion if necessary from the overall electric charge of its molecule.

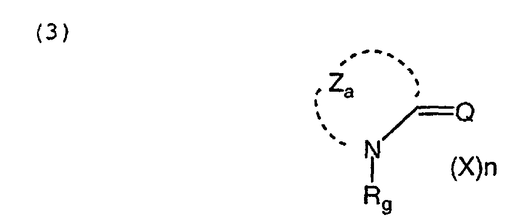

In formula (3), Za is a group of non-metallic atoms necessary to form a nitrogenous heterocycle. Rg is an alkyl or aryl group. Q is a methine or polymethine group necessary for the compound of formula (3) to become a methine dye. It is noted that Za, Rg and Q represent groups which enable the compound of formula (3) to have at least one substituent of the general formula (4). X is a charge equilibrating counter ion. Letter n is a number of 0 to 10 necessary to neutralize the electric charge of the molecule.

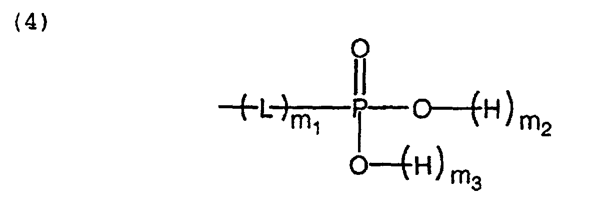

In formula (4), L is an oxygen atom, sulfur atom or imino group, letter m₁ is equal to 0 or 1, m₂ and m₃ each are equal to 0 or 1. Where m₂ or m₃ or both are 0, the substituent of formula (4) has a negative charge.

Illustrative examples of the polymethine dye are described in M. Okawara, T. Kitao, T. Hirasima & M. Matuoka, "Organic Colorants" (Elsevier).

Preferred, illustrative, non-limiting examples of the polymethine dyes of general formulae (2) and (3) are given below.

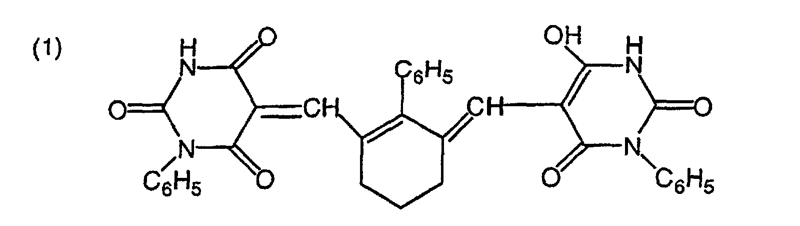

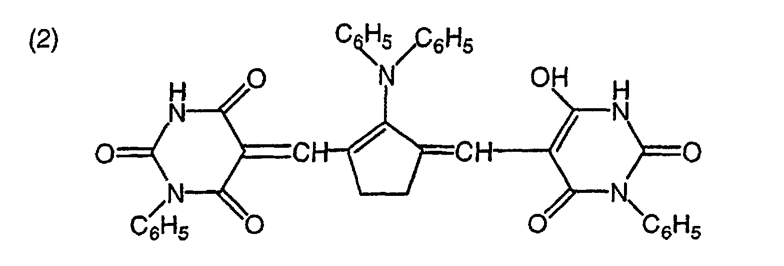

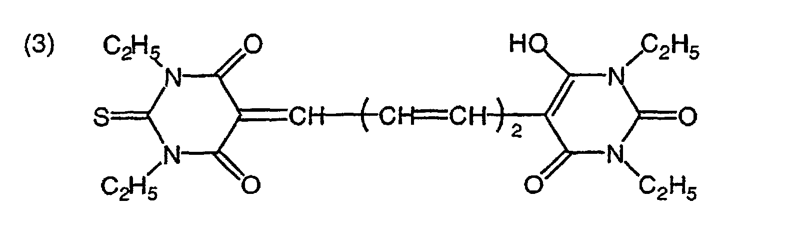

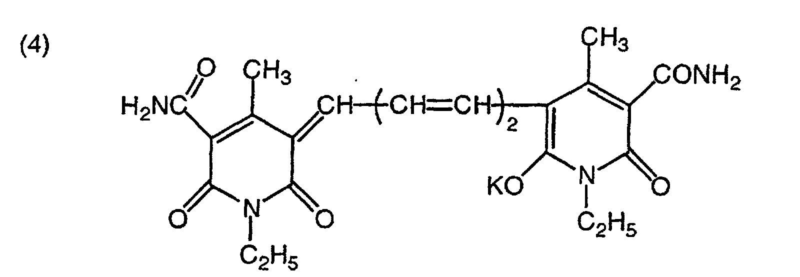

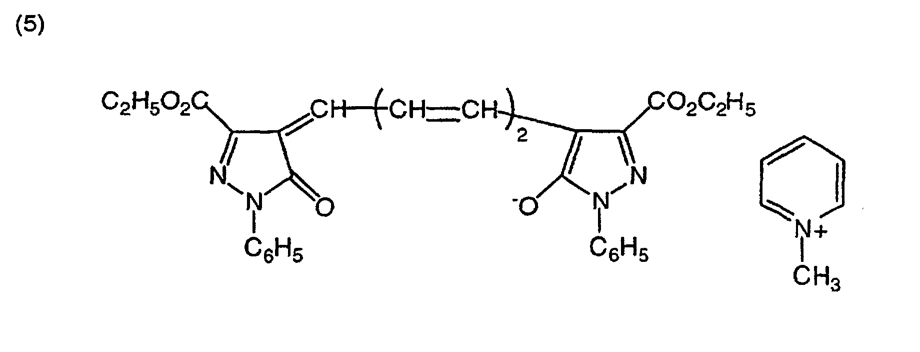

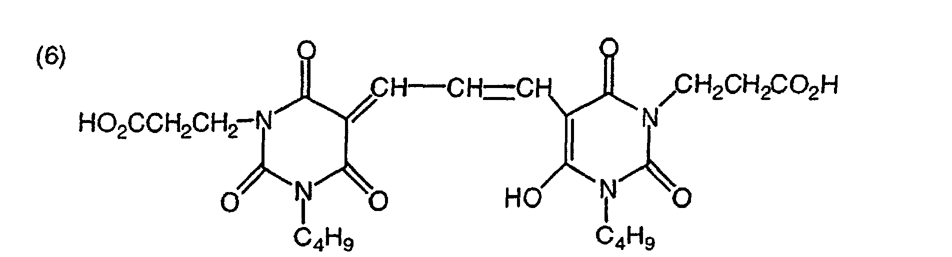

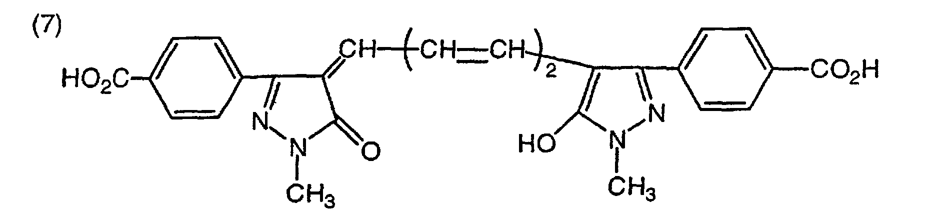

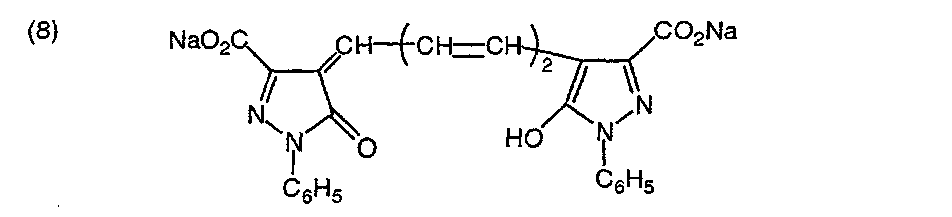

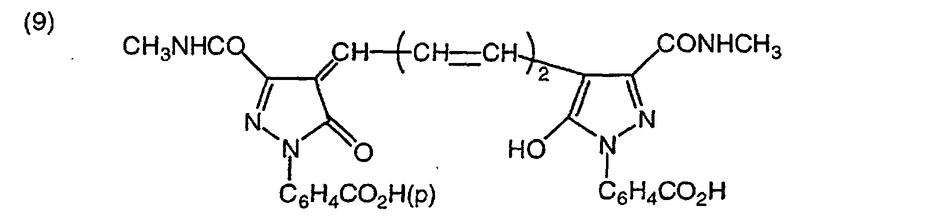

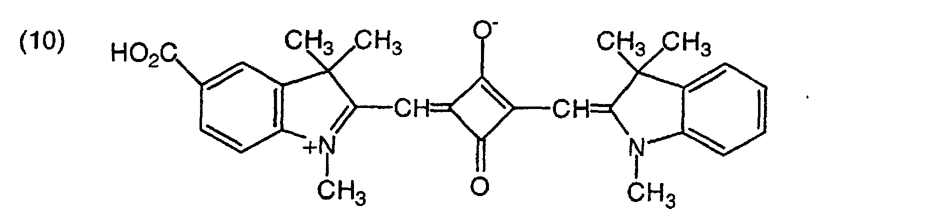

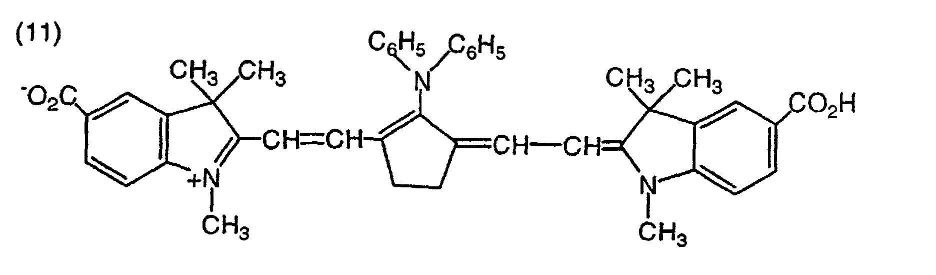

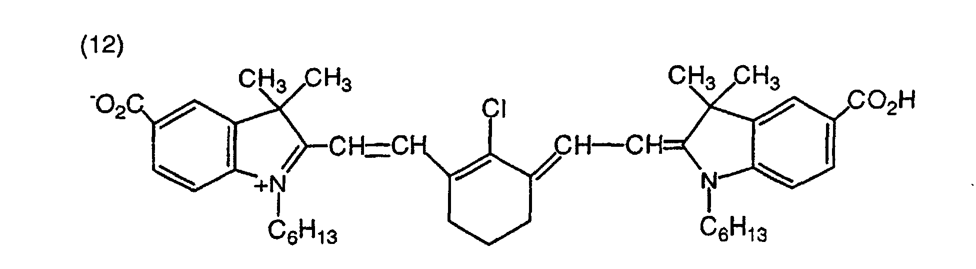

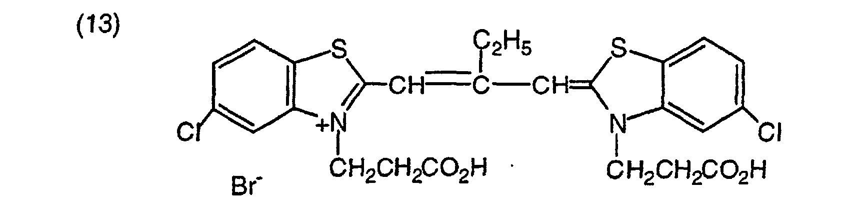

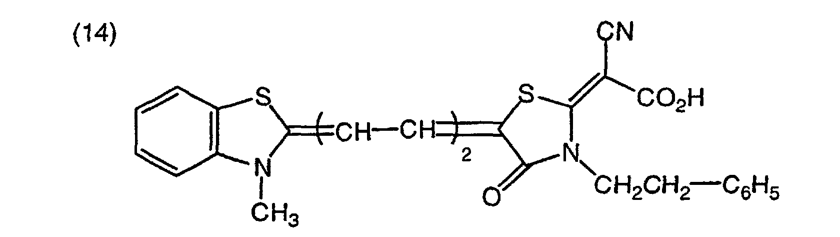

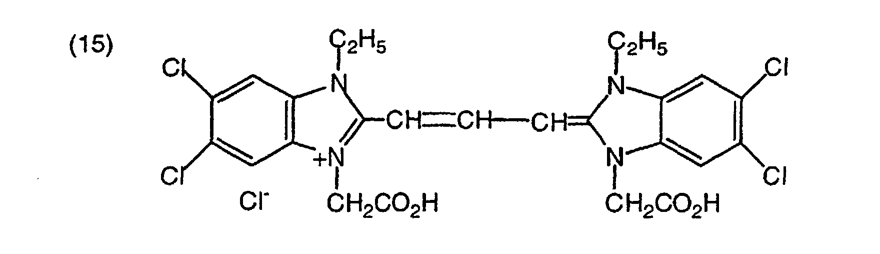

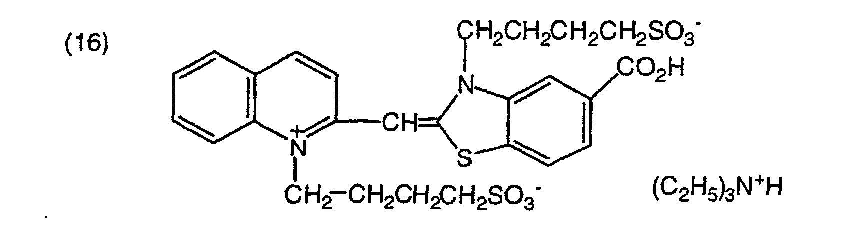

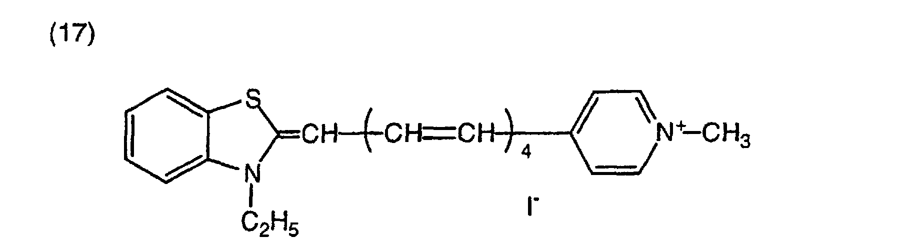

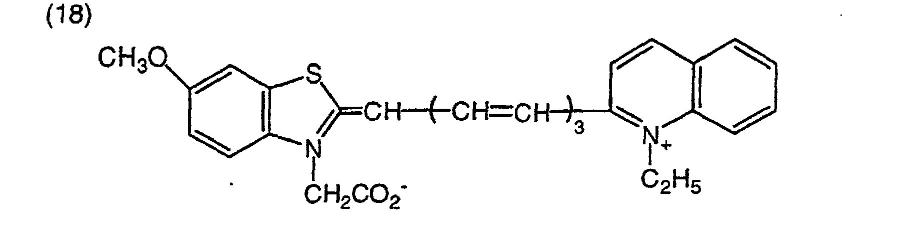

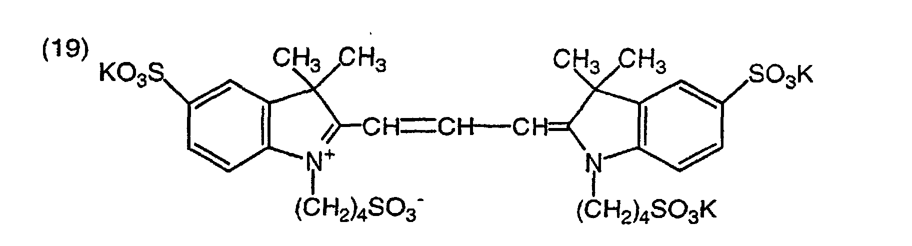

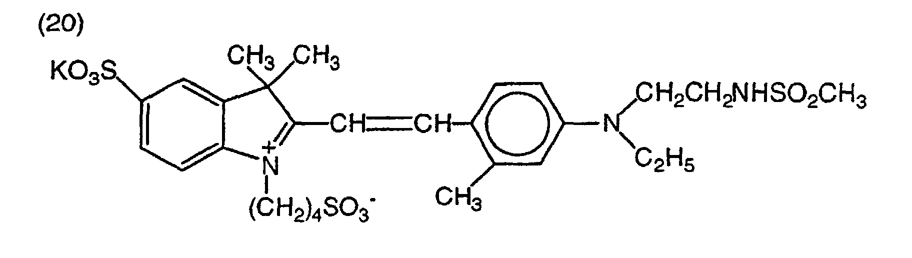

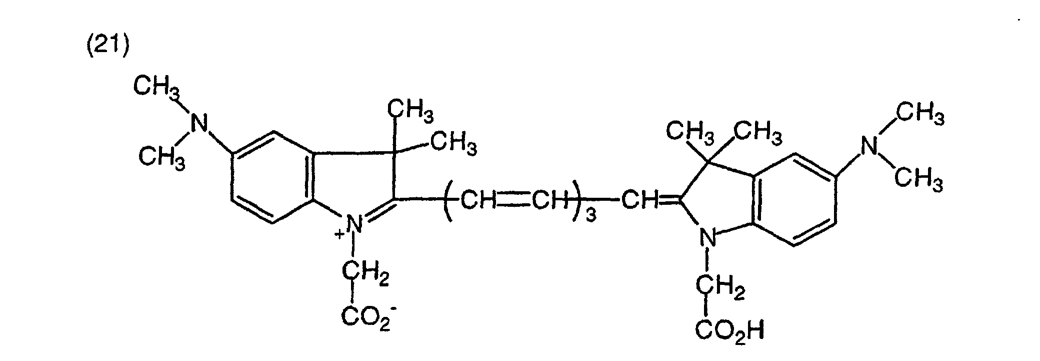

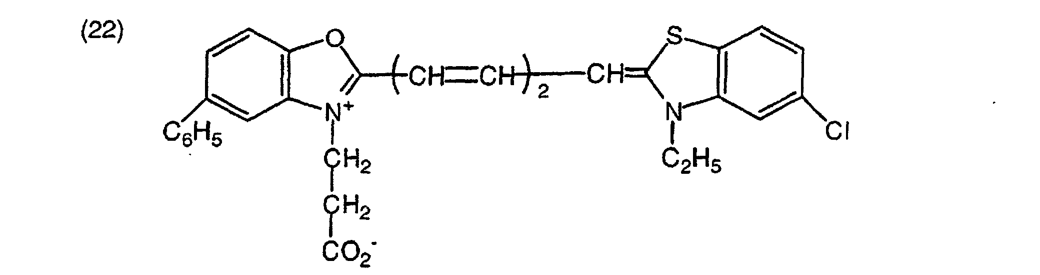

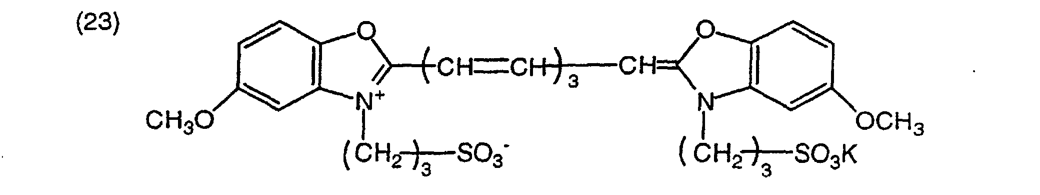

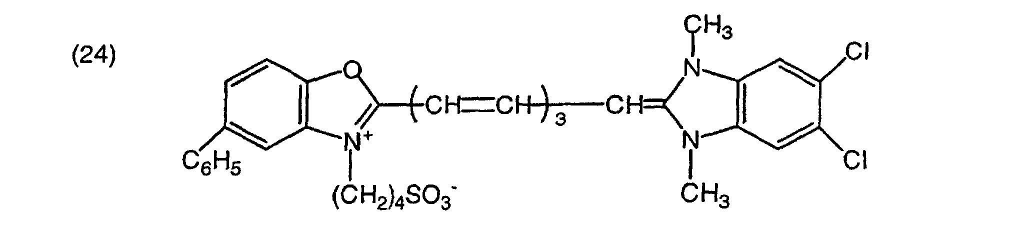

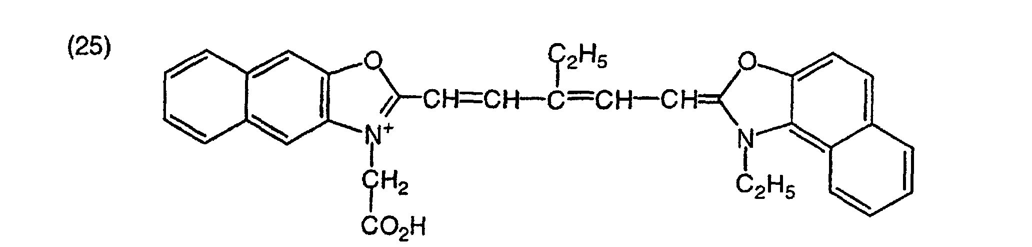

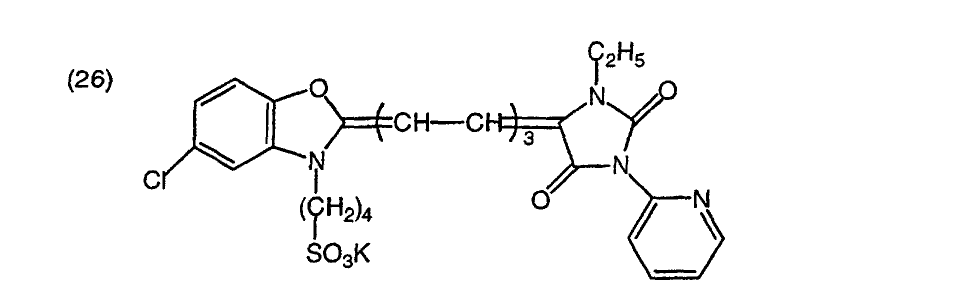

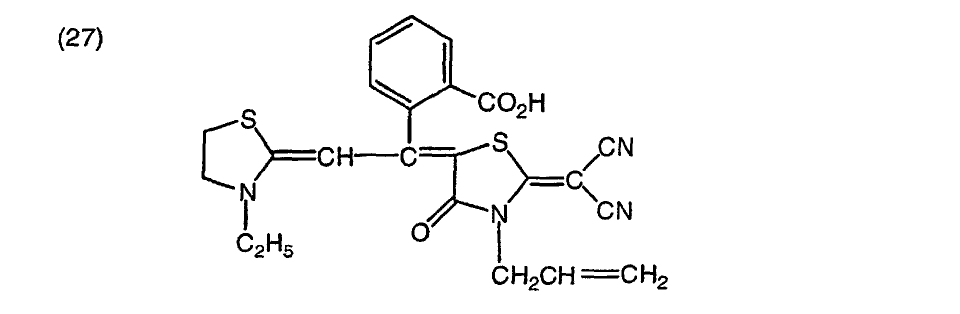

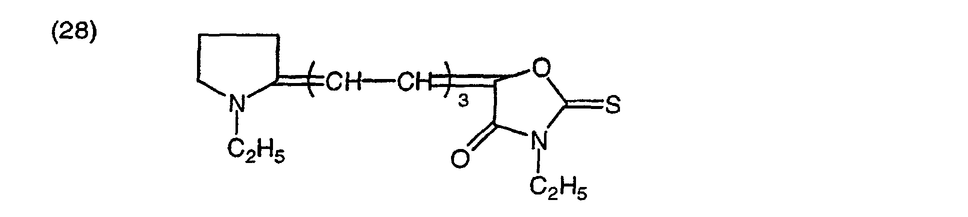

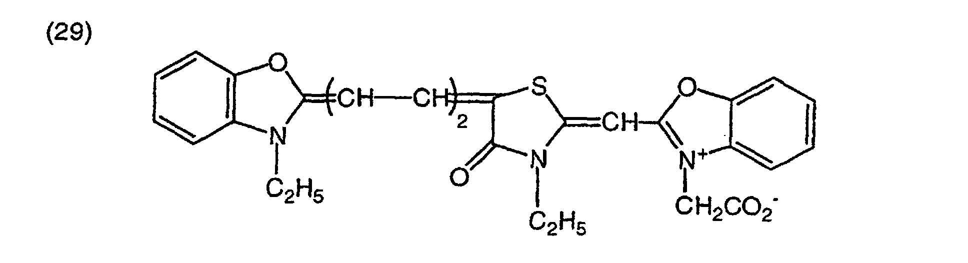

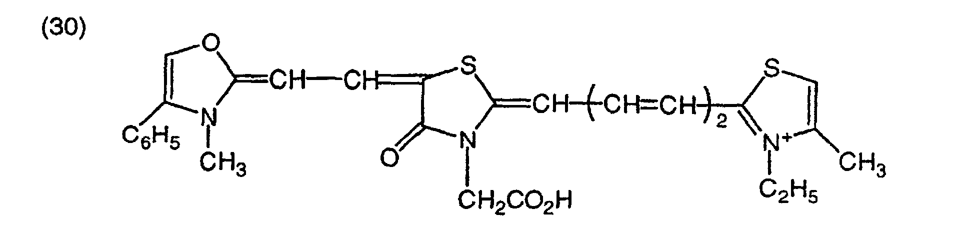

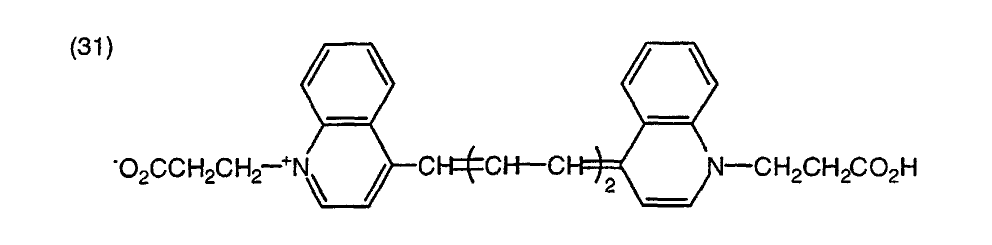

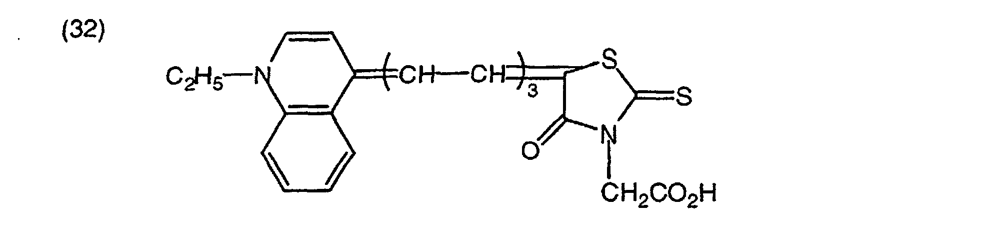

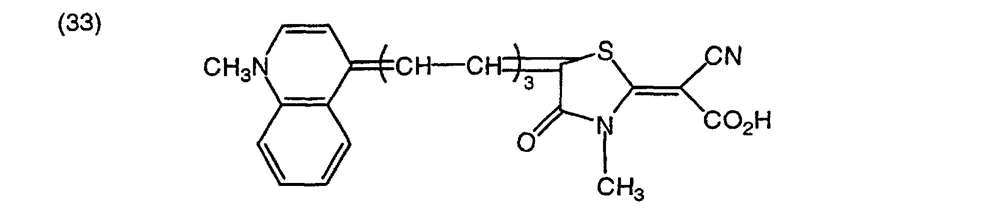

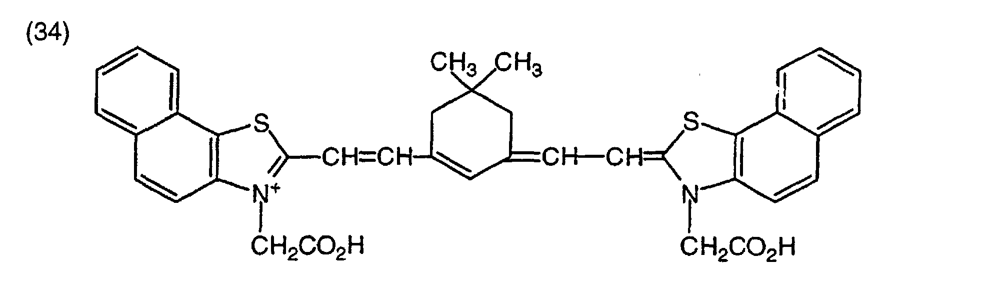

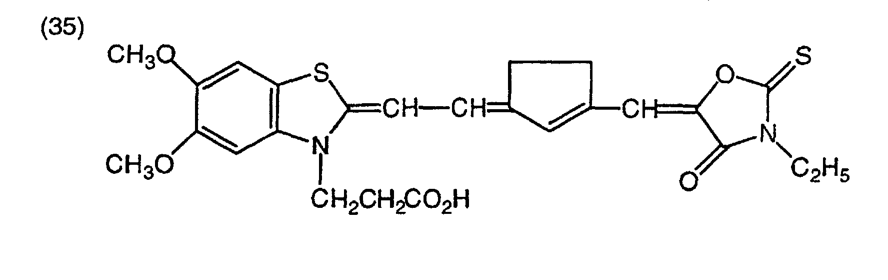

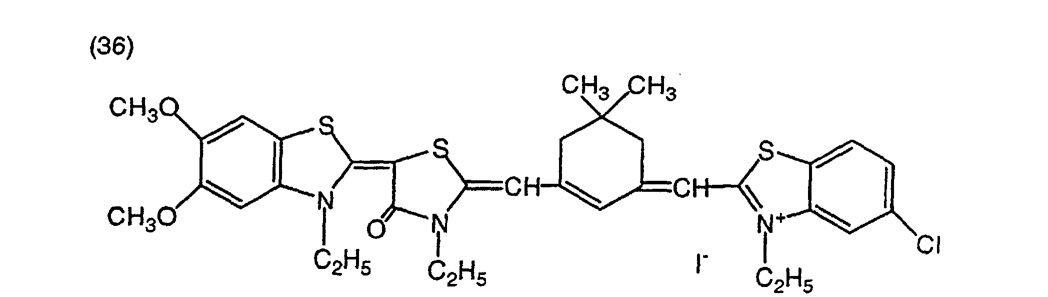

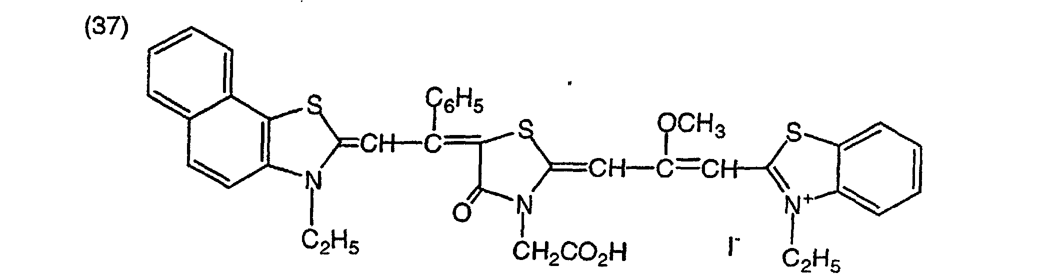

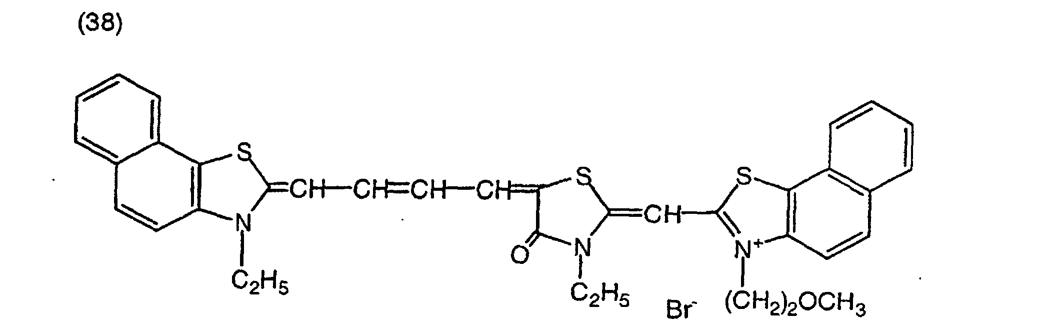

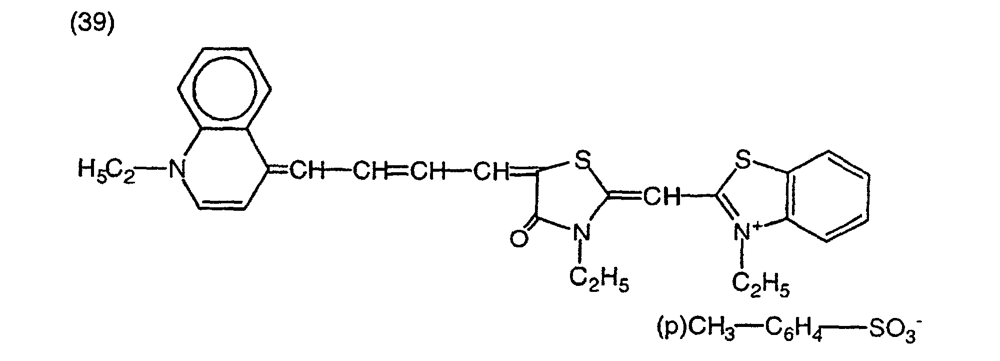

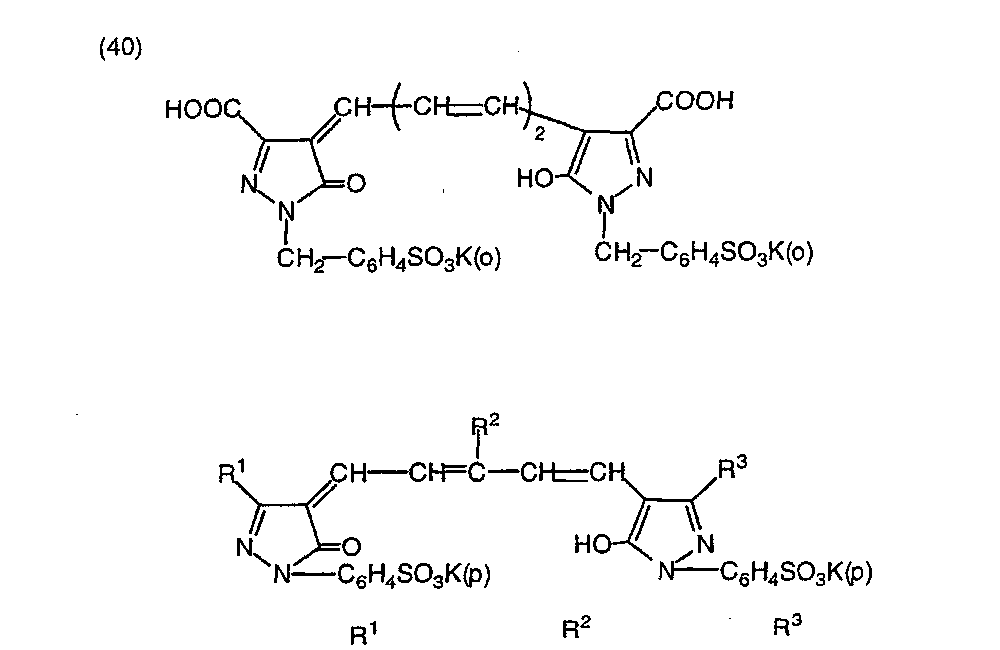

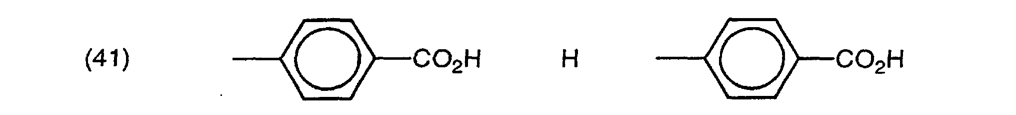

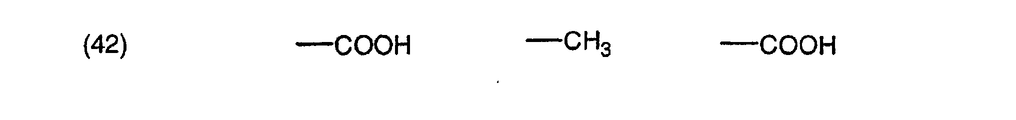

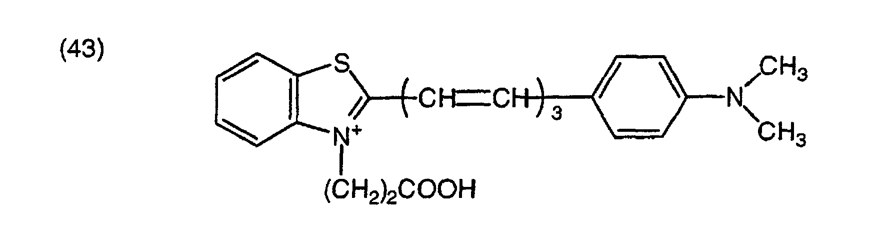

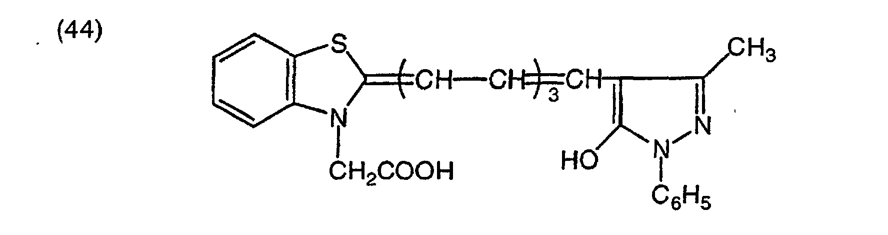

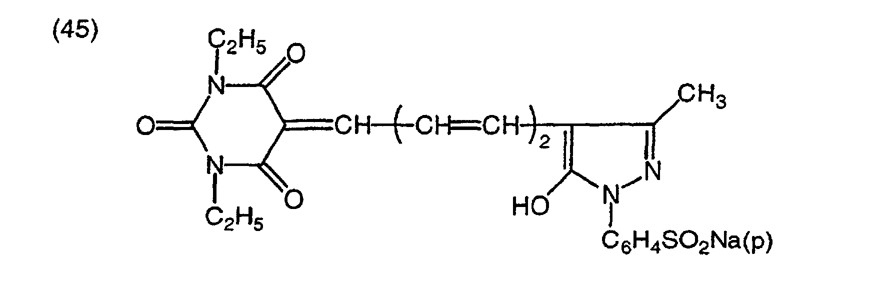

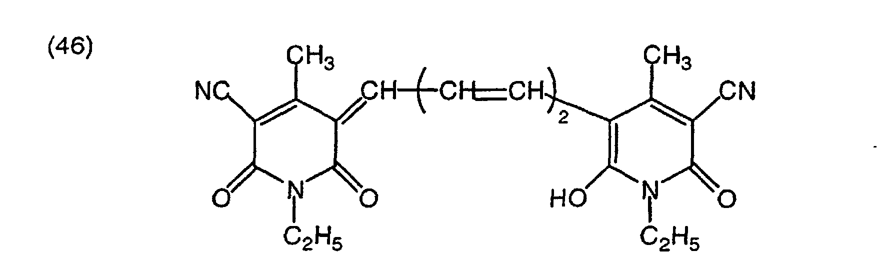

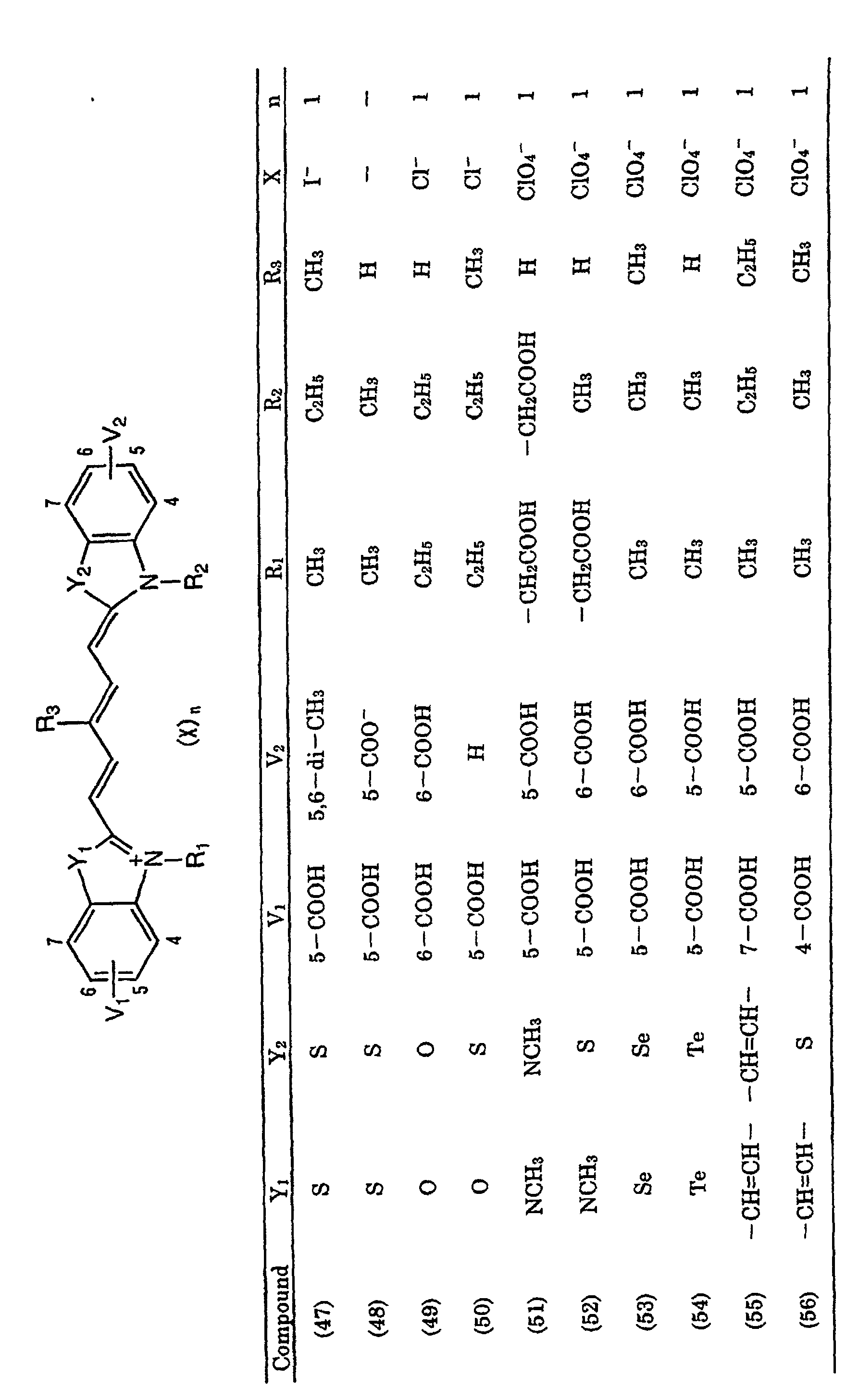

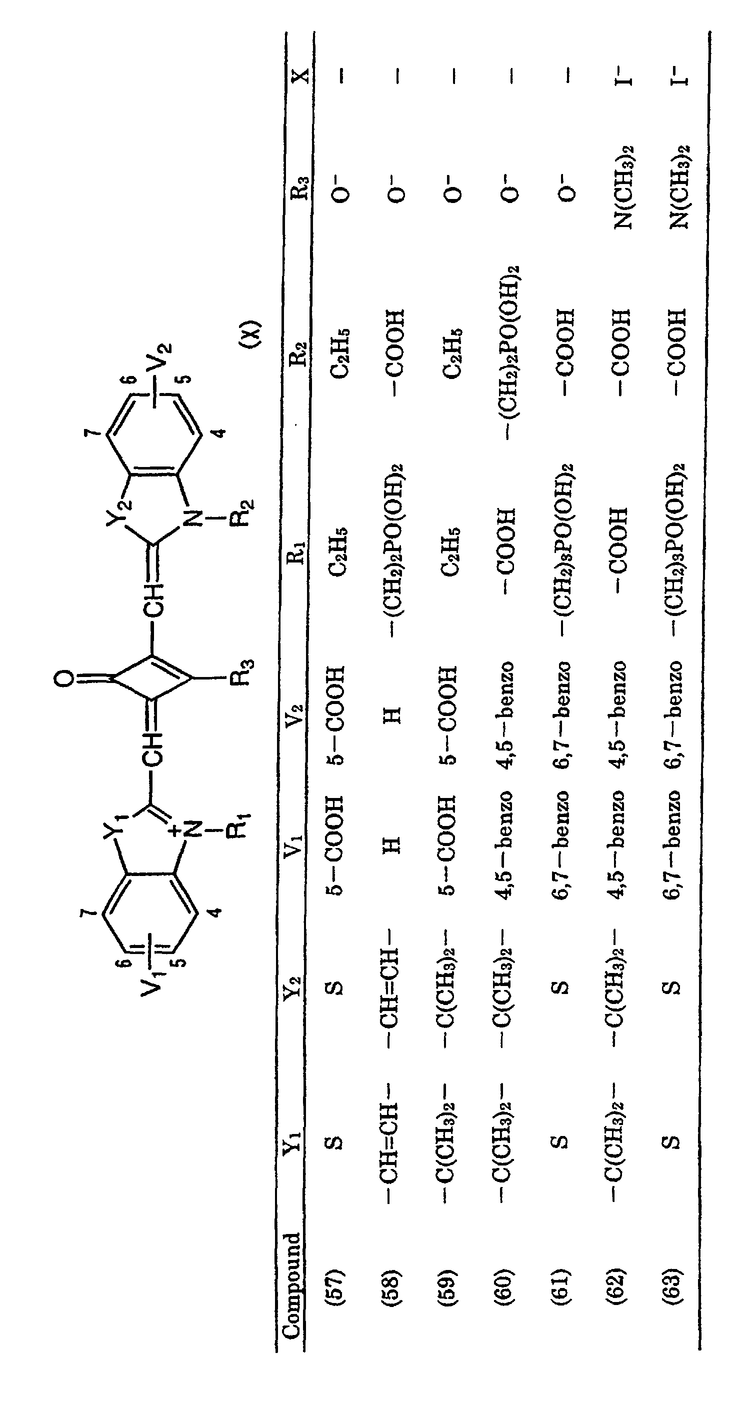

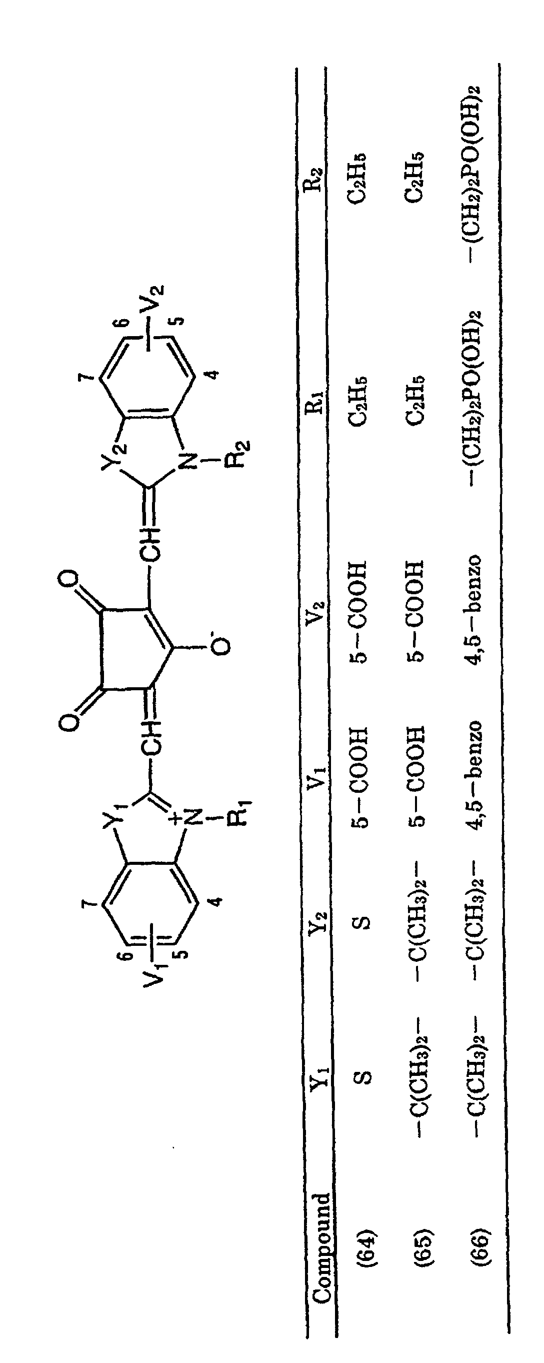

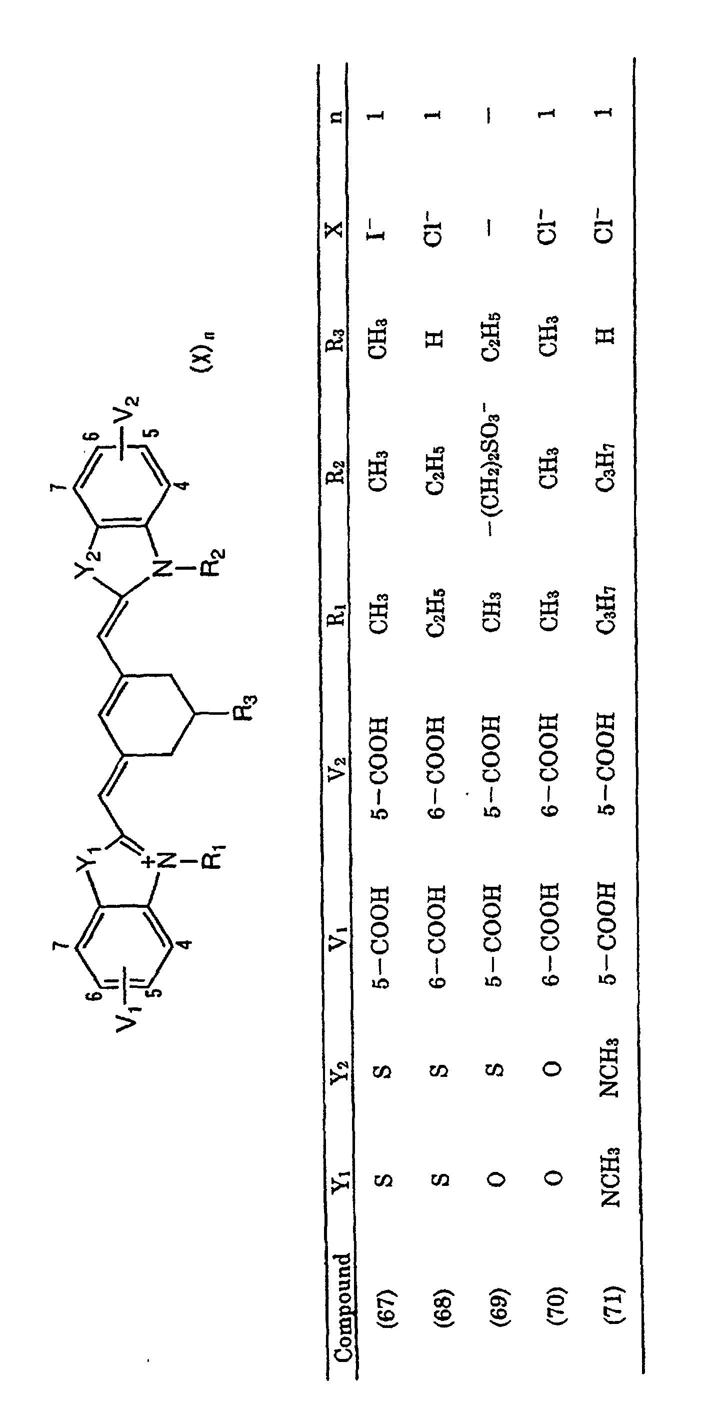

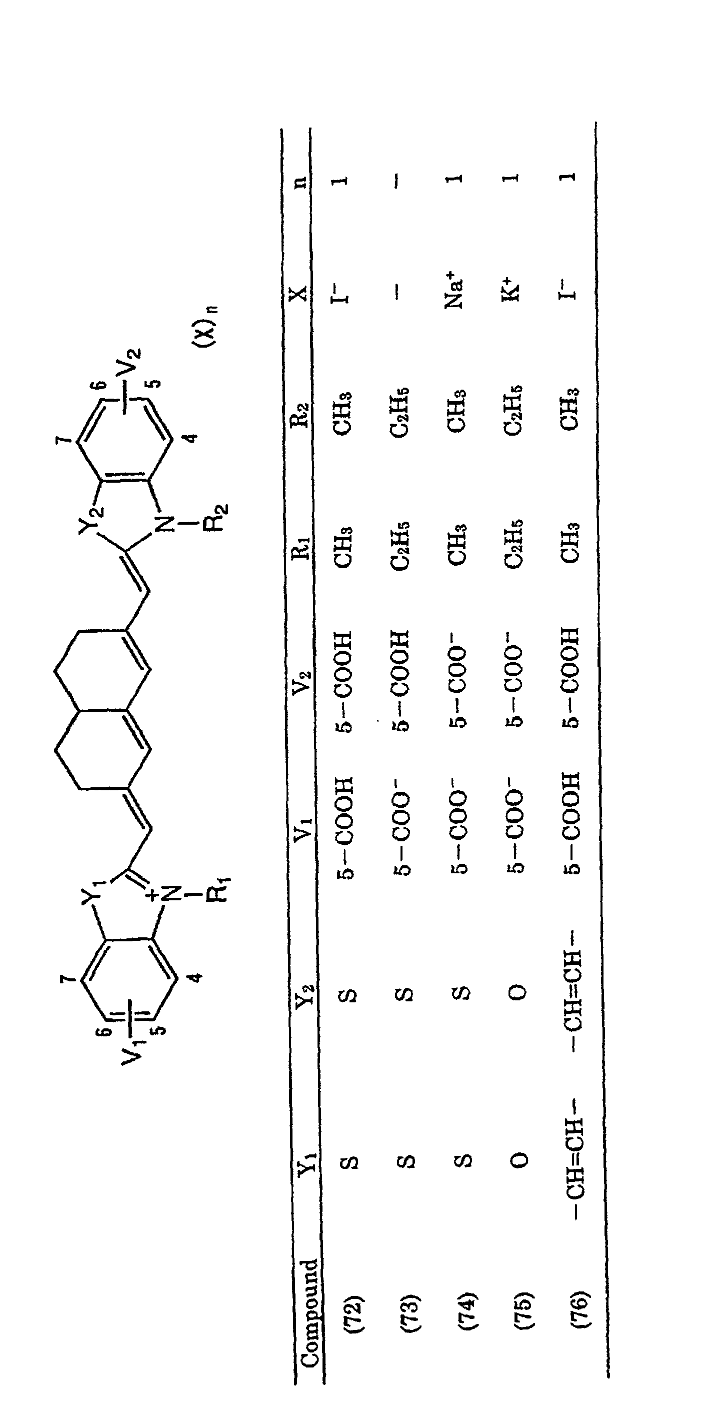

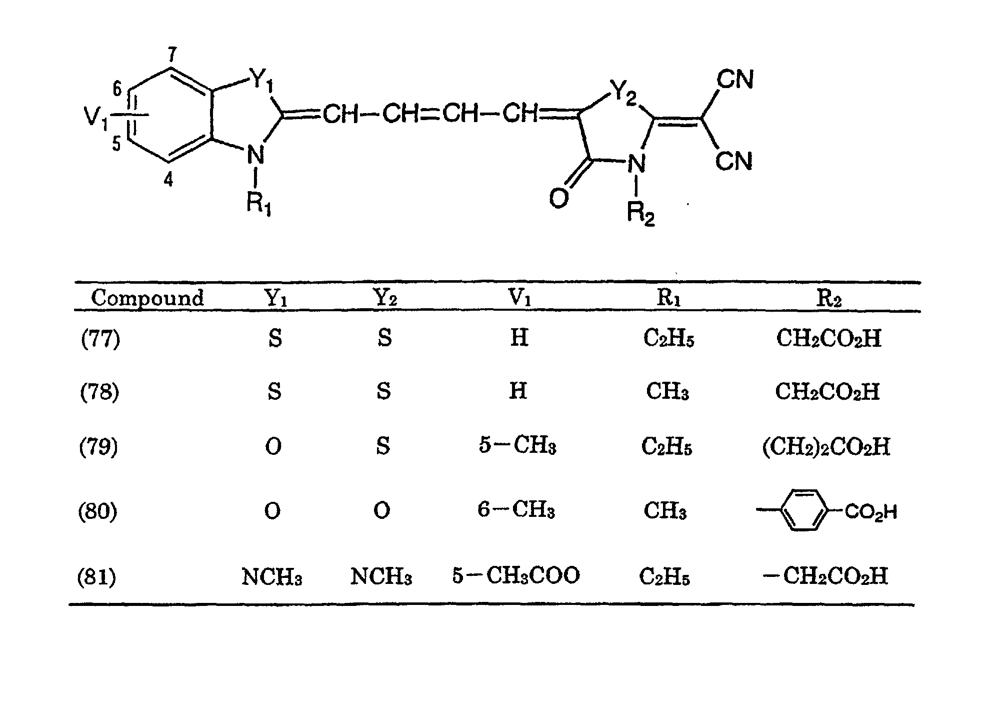

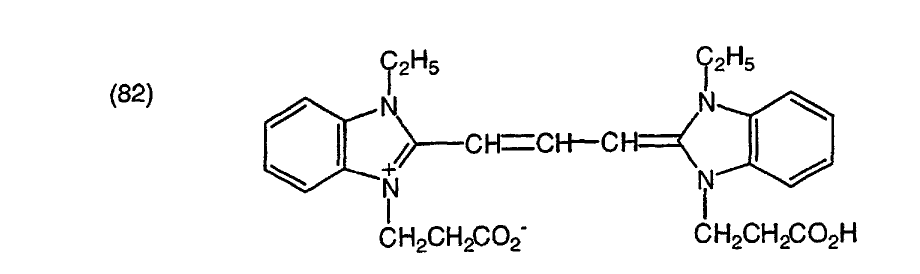

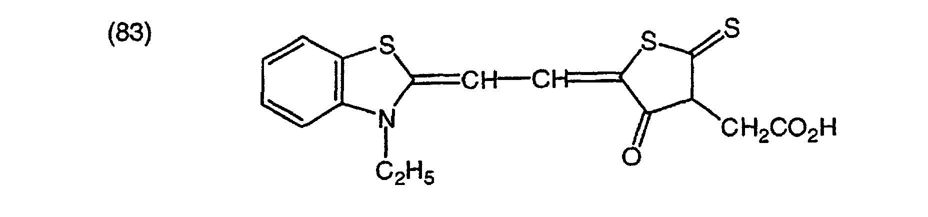

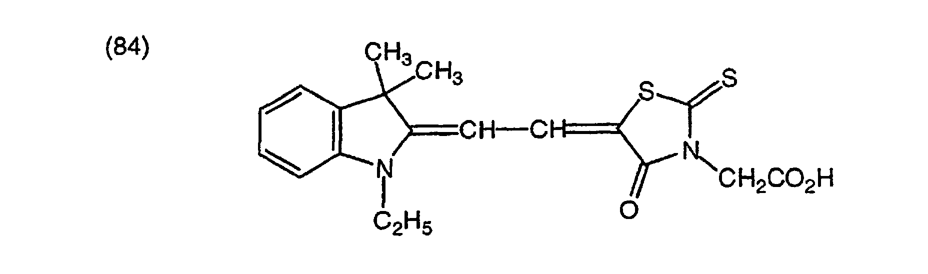

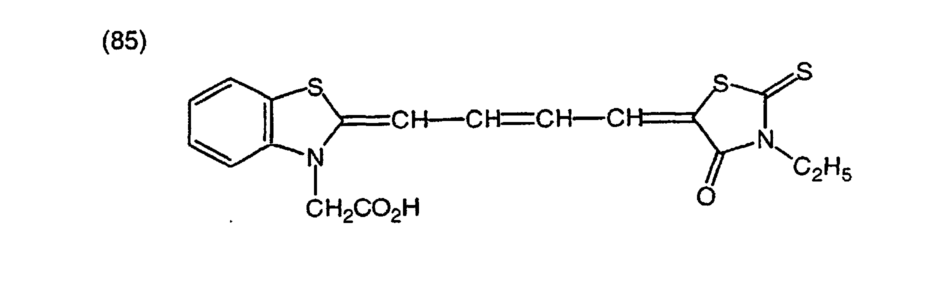

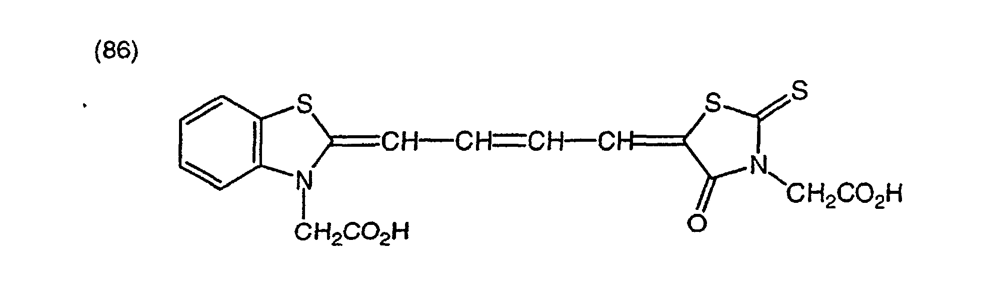

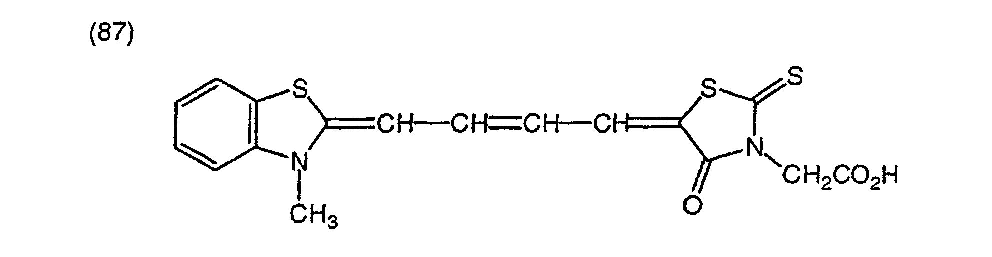

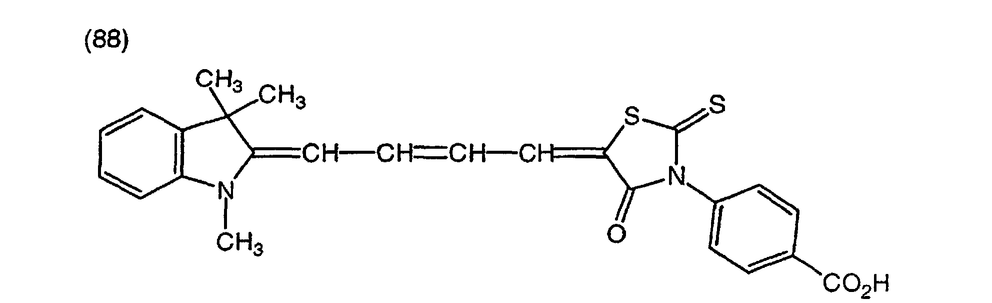

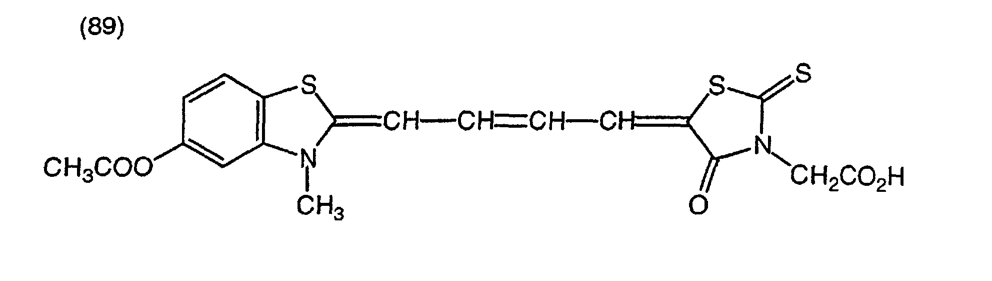

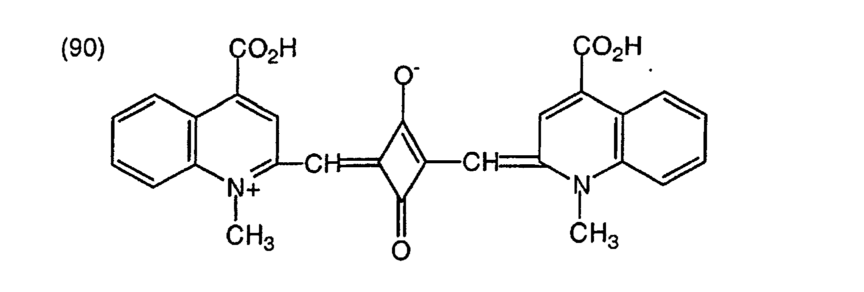

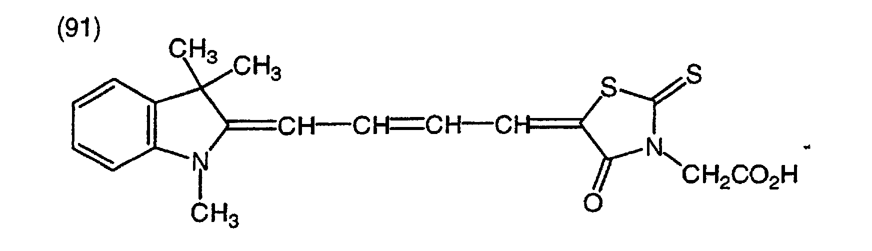

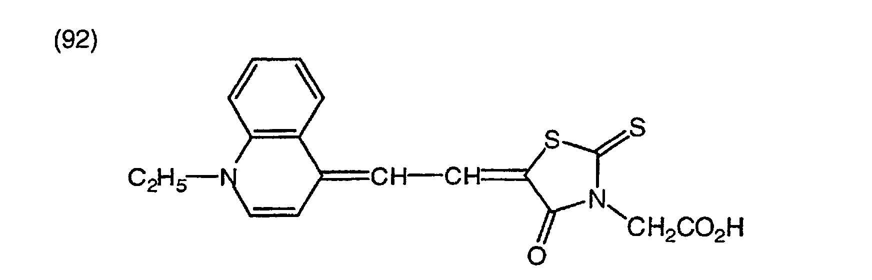

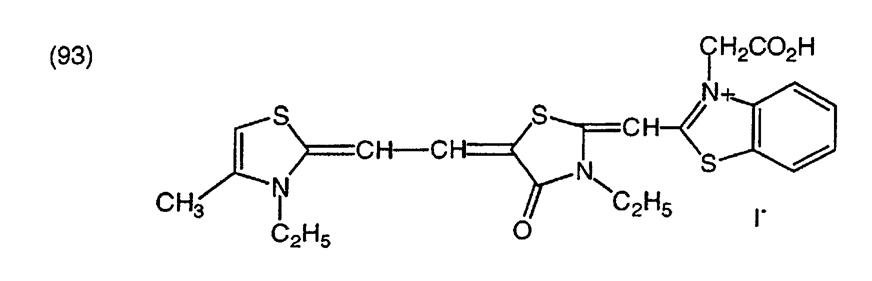

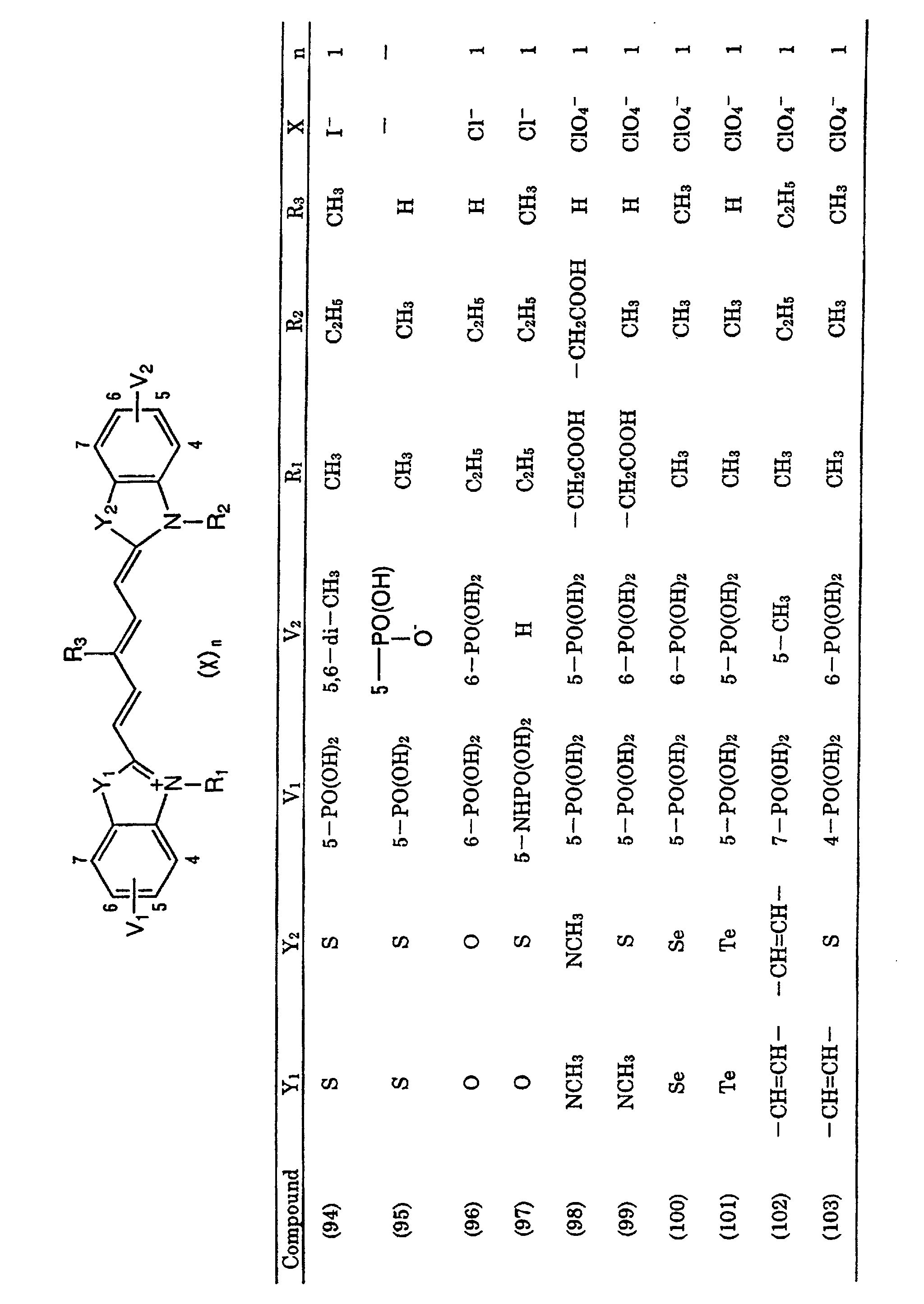

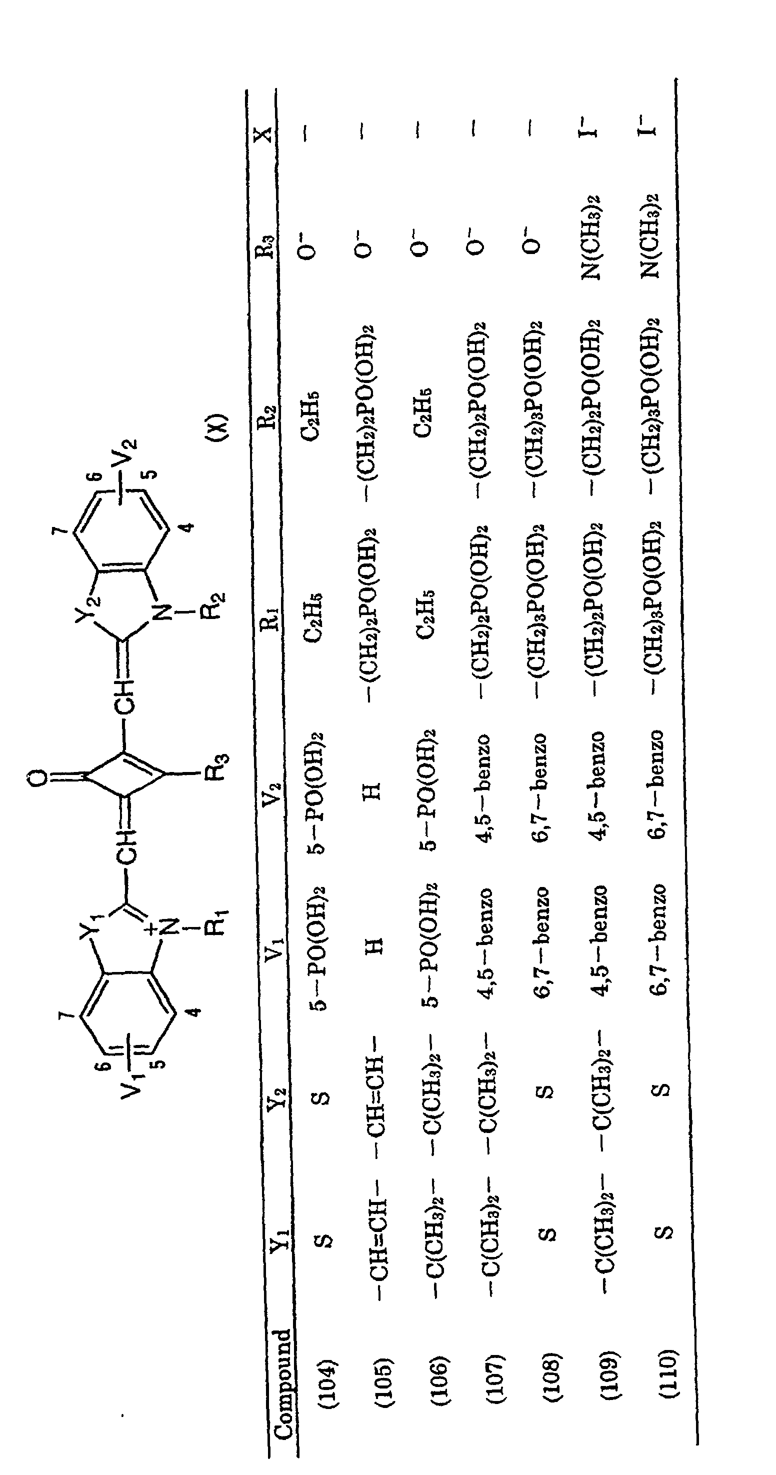

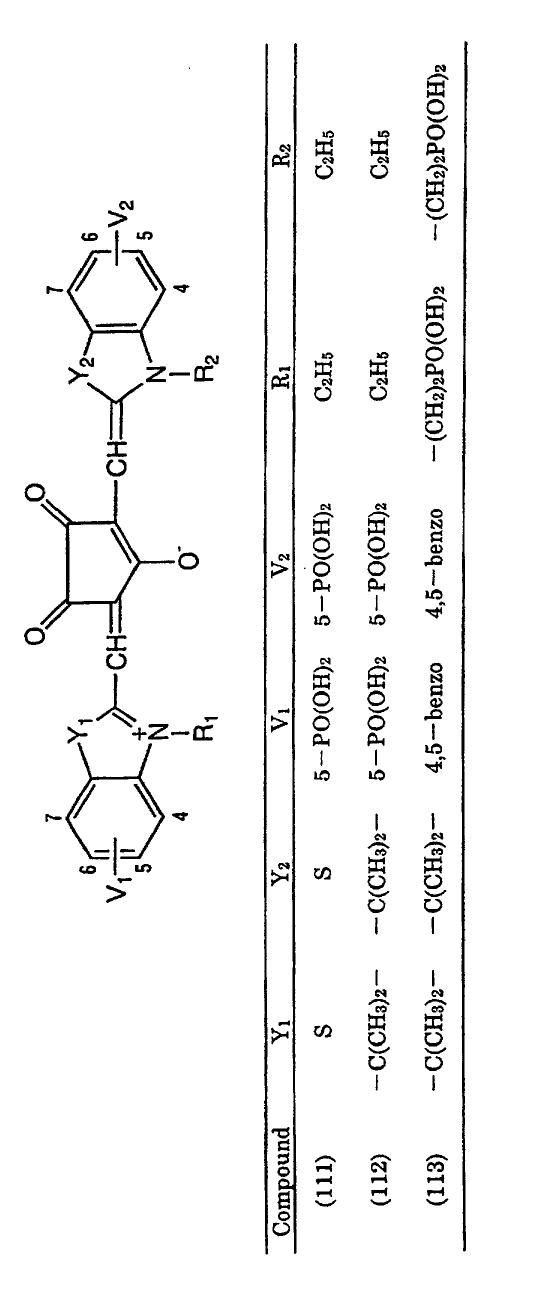

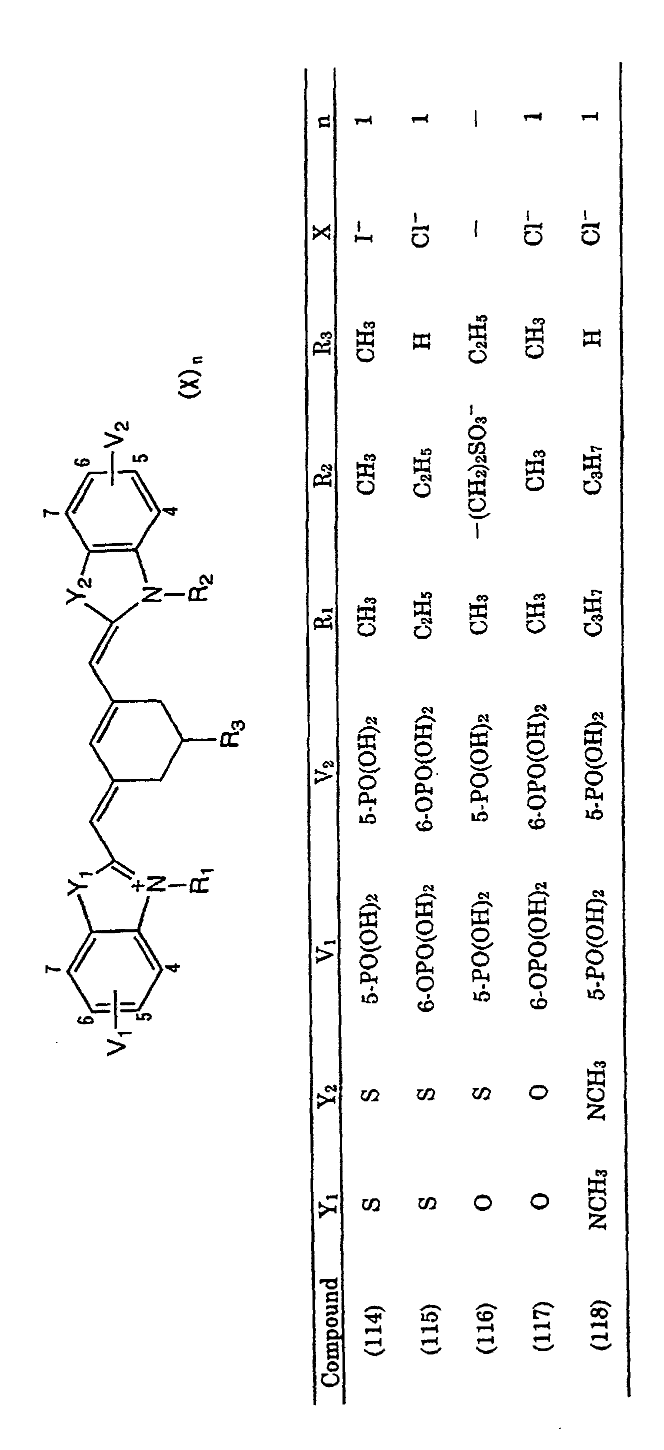

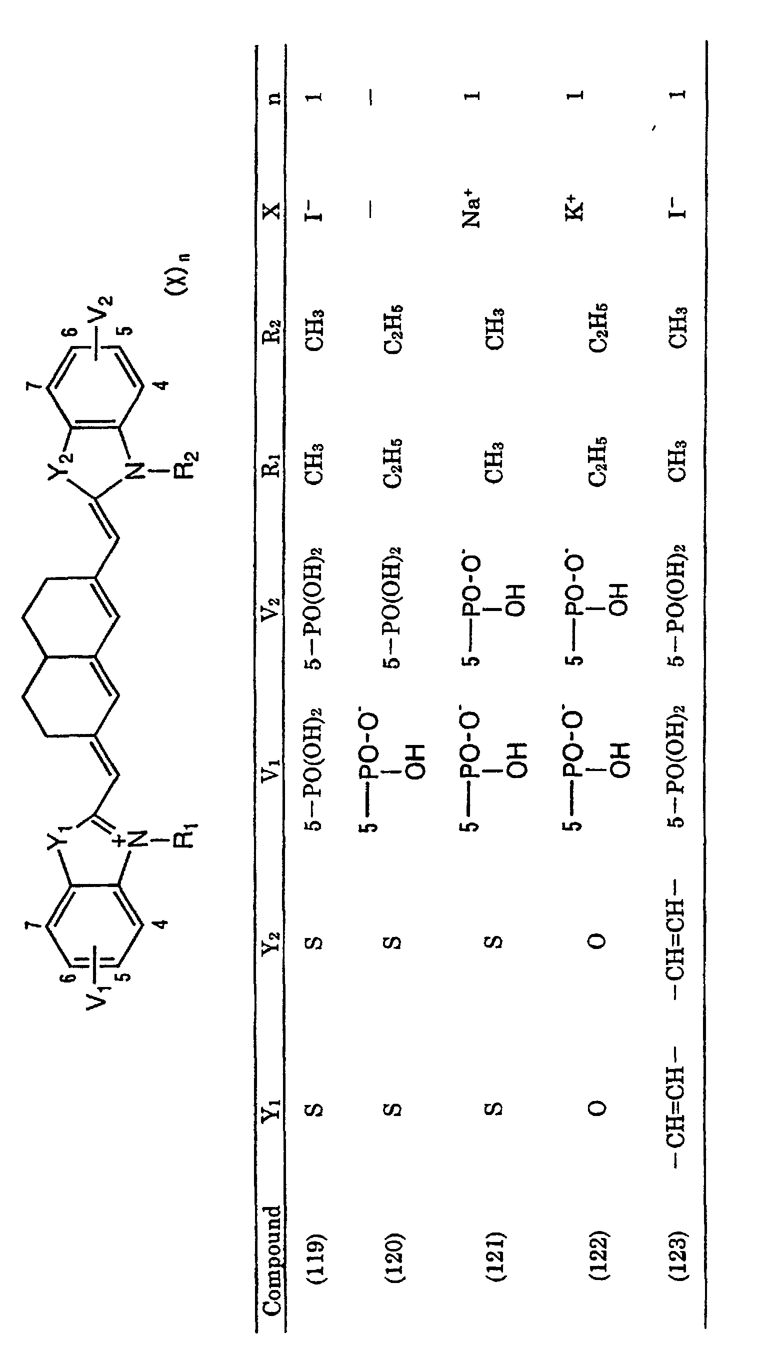

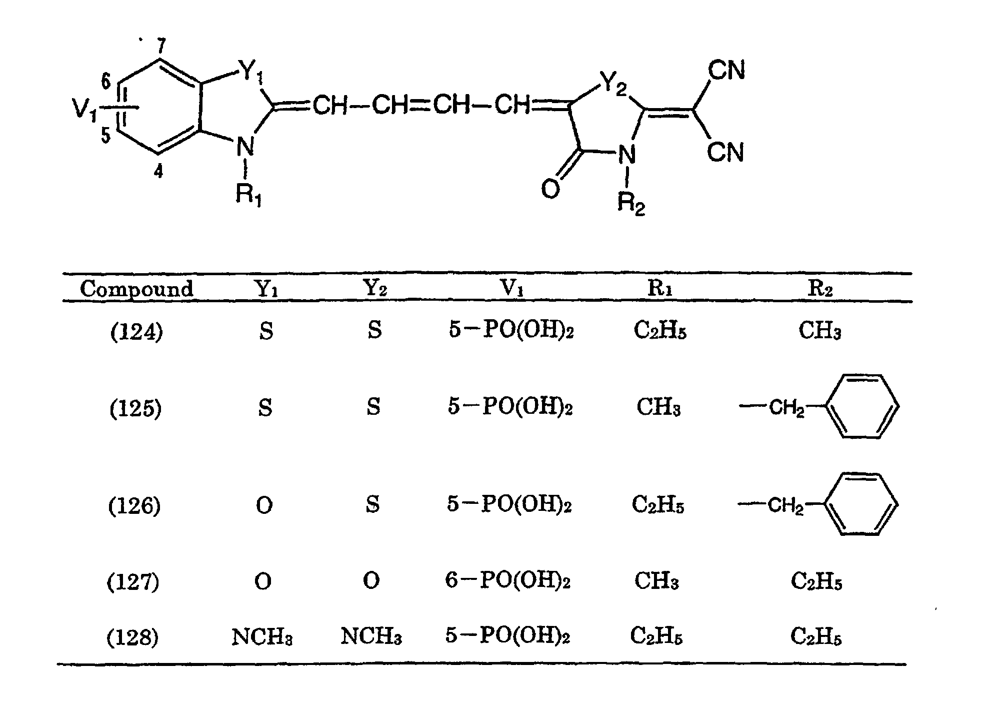

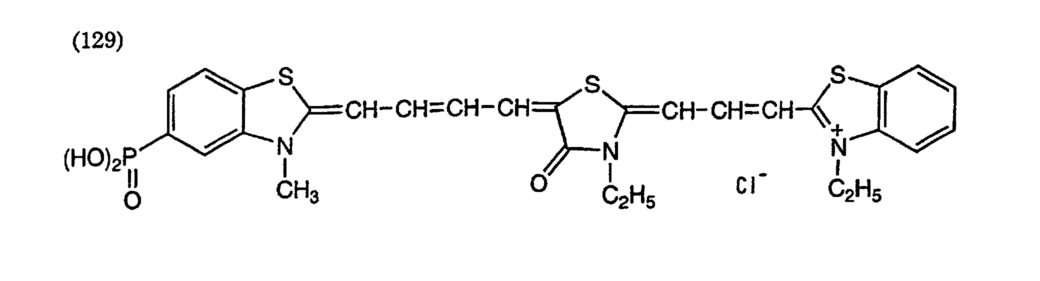

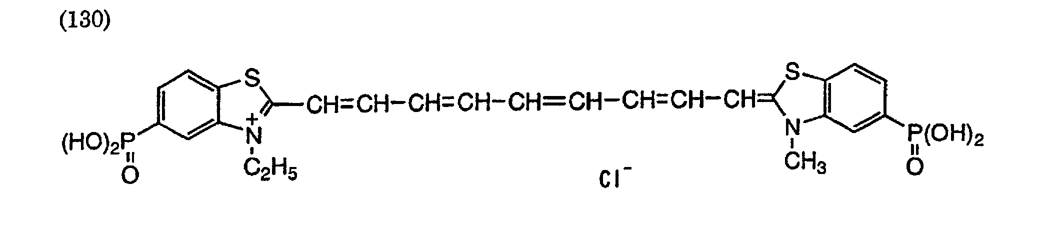

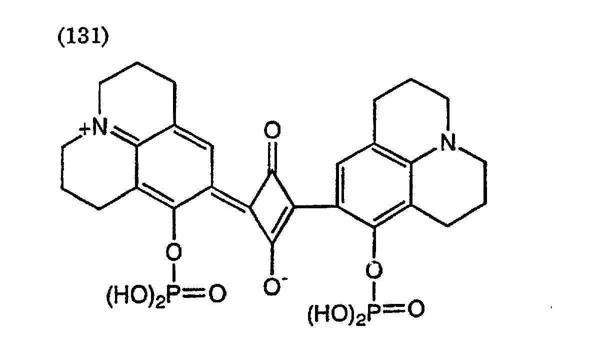

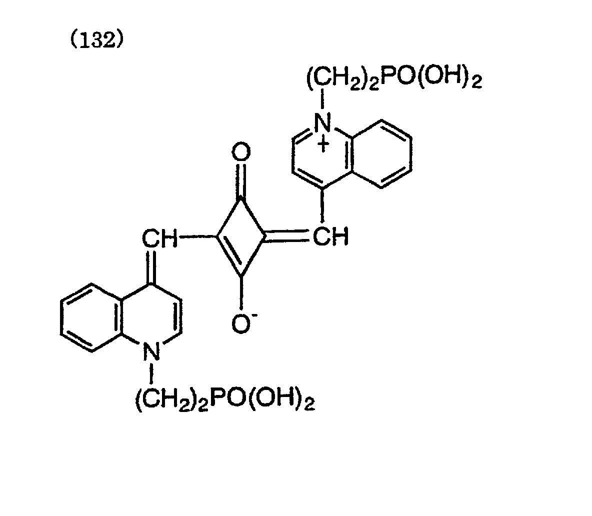

The compounds of general formulae (2) and (3) can be synthesized by the methods described in F.M. Harmer, Heterocyclic Compounds - Cyanine Dyes and Related Compounds, John Wiley & Sons, New York, London, 1964; D.M. Sturmer, Heterocyclic Compounds - Special topics in heterocyclic chemistry," Chap. 18, Sec. 14, pp. 482-515, John Wiley & Sons, New York, London, 1977; Rodd's Chemistry of Carbon Compounds, 2nd Ed., vol. IV, part B, 1977, Chap. 15, pp. 369-422, Elsevier Science Publishing Company Inc., New York; and British Patent No. 1,077,611.

The dye is adsorbed to semiconductor nanoparticulates, most often by immersing fully dry semiconductor nanoparticulates in a dye solution for several hours. The dye adsorption may be done at room temperature or by heating under reflux as described in JP-A 249790/1995. The dye adsorption may be done either prior to or subsequent to the coating of semiconductor nanoparticulates. It is also acceptable that semiconductor nanoparticulates and the dye are simultaneously coated whereupon adsorption takes place. It is desirable to remove the unadsorbed dye by washing. Where the coated film is fired, it is preferred that the dye adsorption be done subsequent to firing. It is especially preferred that the dye is quickly adsorbed to the coated film after firing and before water adsorbs to the surface of the coated film. For adsorption, a single dye or a mixture of dyes may be used. For the application to photo-regenerative photo-electrochemical cells, dyes are selected and mixed so as to make the wavelength range of photoelectric conversion as broad as possible.

The overall amount of the dye used is preferably 0.01 to 100 mmol per square meter of the support. The amount of the dye adsorbed to semiconductor nanoparticulates is preferably 0.01 to 1 mmol per gram of the semiconductor nanoparticulates. An amount of the dye in this range provides a sufficient semiconductor sensitizing effect. Less amounts of the dye would provide an insufficient sensitizing effect. If the amount of the dye is too much, the dye that is not adsorbed to the semiconductor would float, detracting from the sensitizing effect.

Also for the purpose of reducing the association or interaction between dyes, a colorless compound may be co-adsorbed. Hydrophobic compounds to be co-adsorbed are steroid compounds having a carboxyl group, e.g., cholic acid.

After the adsorption of the dye, the semiconductor nanoparticulates may be surface treated with amines. Preferred amines are pyridine, 4-tert-butylpyridine and polyvinylpyridine. The amines may be used as such if they are liquid or as solutions in organic solvents.

Next, the gelling agent used herein is described in detail. In general, the term gel designates the state that colloid particles or polymeric solutes lose independent mobility due to their interaction, coalesce to form a structure and solidify. The gelling agent used herein has a molecular weight of up to 1,000 and typically from 100 to 1,000. The gelling agent used herein may be any of the compounds that can cause an organic solvent to solidify or gel when the gelling agent is added to the solvent in a concentration of up to 500 g/liter, typically 0.1 to 500 g/liter. The gelling agent used herein may be a compound that self associates in a solution to form a gel structure by utilizing as a driving force a secondary interaction such as a hydrogen bond, electrostatic interaction, coordination bond, van der Waals force, or π-π electron interaction rather than a covalent bond. Such compounds are not so many, and known compounds include dibenzylidene-D-sorbitol, cholesterol derivatives, amino acid derivatives, alkylamide derivatives of trans-(1R,2R)-1,2-cyclohexanediamine, alkylurea derivatives, N-octyl-D-gluconamidebenzoate, and twin-head amino acid derivatives. Reference should be made to J. Chem. Soc. Japan, Ind. Chem. Soc., 46, 779 (1943), J. Am. Chem. Soc., 111, 5542 (1989), J. Chem. Soc., Chem. Commun., 1993, 390, Angew. Chem. Int. Ed. Engl., 35, 1949 (1996), Chem. Lett., 1996, 885, and J. Chem. Soc., Chem. Commun., 1997, 545.

Preferred non-limiting examples of the gelling agent which can be used herein are given below.

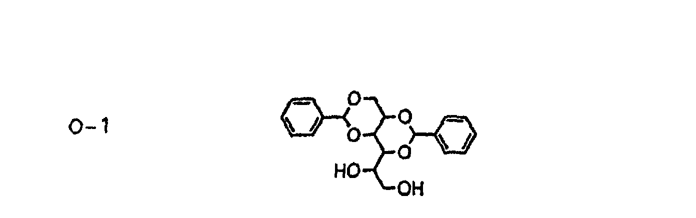

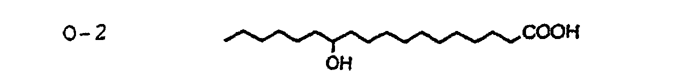

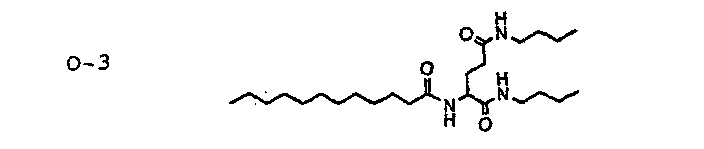

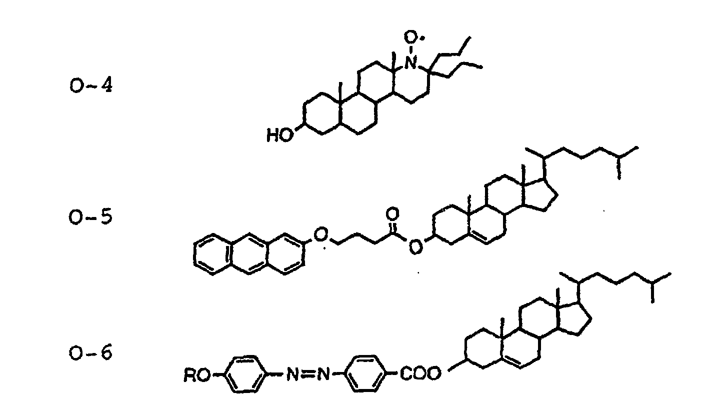

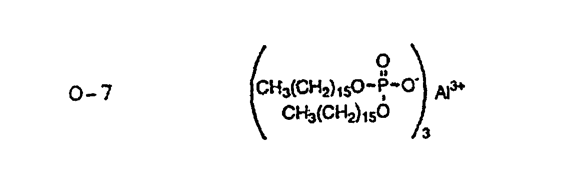

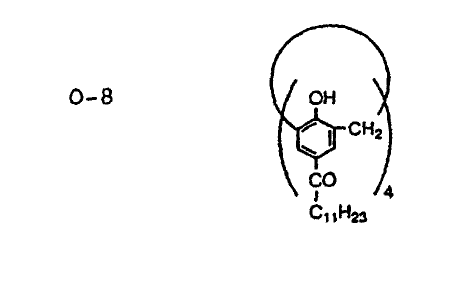

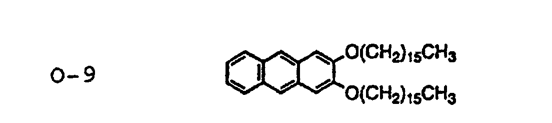

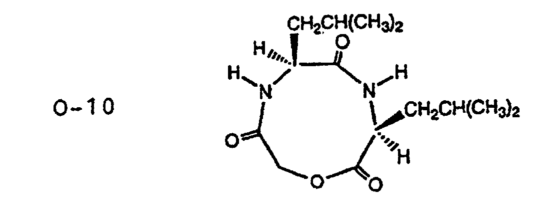

O-11 F(CF₂)ₙ(CH₂)ₘH

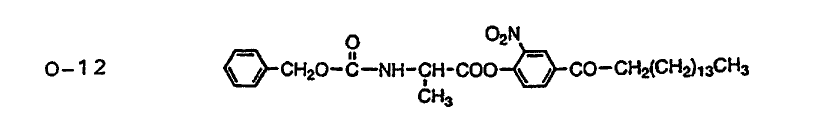

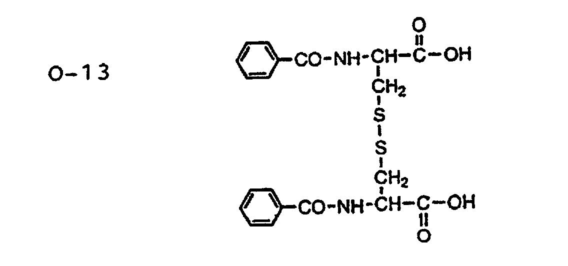

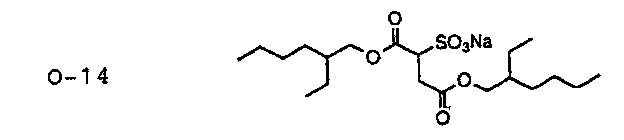

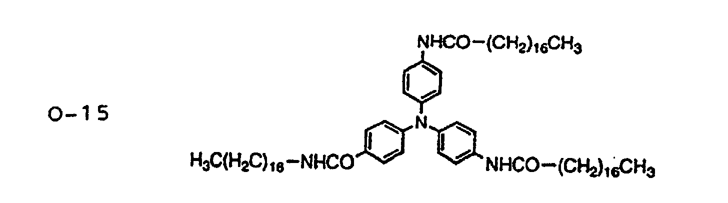

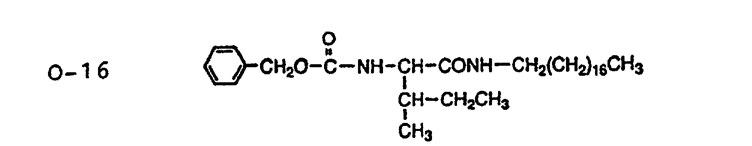

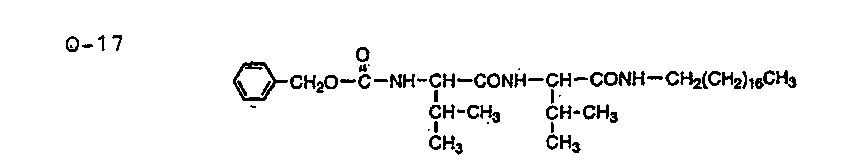

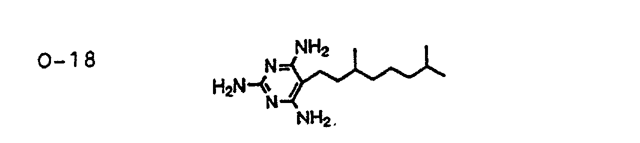

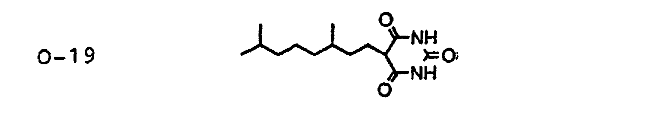

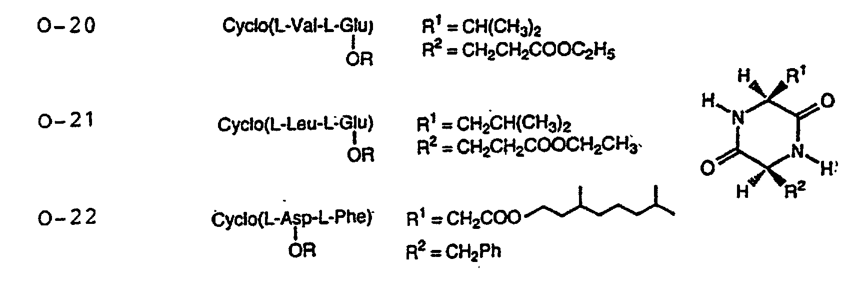

O-23 R=CHMe₂, n=5.0, m=18

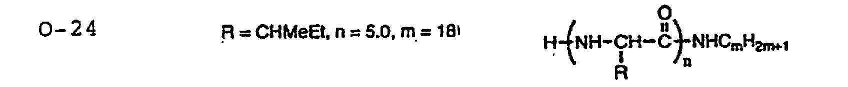

O-25 R=CH₂Ph,n=5.1,m=12

O-26 R = CH₂CH₂CO₂Me, n = 4.2, m = 12

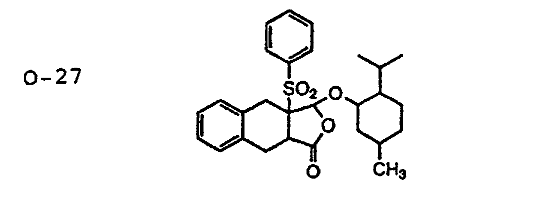

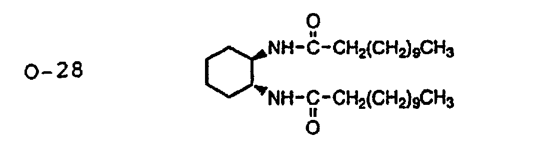

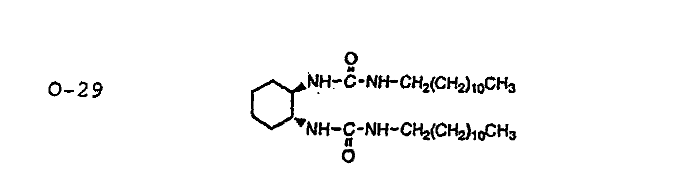

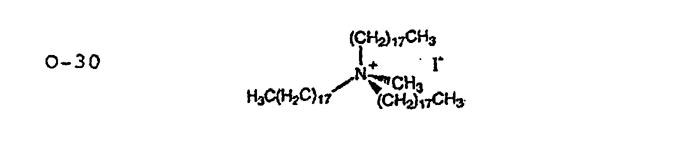

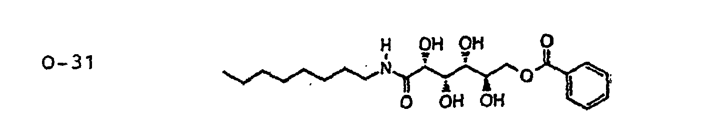

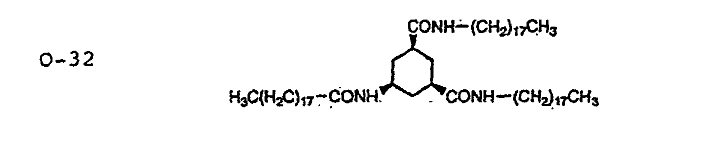

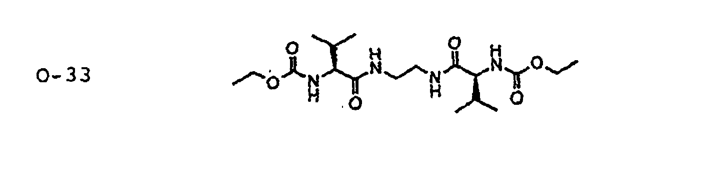

The gelling agent is preferably present in the gel electrolyte in a concentration of 0.2 to 500 g/liter, more preferably 0.5 to 300 g/liter. Better effects are achieved with a gelling agent concentration in this range. A lower concentration of the gelling agent would induce an insufficient progress of gelation, detracting from the stability of photoelectric converter performance. A higher concentration of the gelling agent would adversely affect the initial performance, especially photocurrent density, of photoelectric converters.

The components that construct the gel electrolyte with the gelling agent according to the invention are an electrolyte and a solvent, which are described below. The electrolyte used herein may be selected from among metal iodides such as LiI, NaI, KI, CsI, and CaI₂; iodide salts of quaternary imidazolium compounds, iodide salts of quaternary pyridinium compounds, iodide salts of tetraalkylammonium compounds; Br₂ and metal bromides such as LiBr, NaBr, KBr, CsBr, and CaBr₂, Br₂ and bromide salts of quaternary ammonium compounds such as tetraalkylammonium bromide and pyridinium bromide; metal complexes such as ferrocyanate-ferricyanate salts and ferrocene-ferricinium ions; sulfur compounds such as sodium polysulfide and alkylthiol-alkyldisulfides; viologen dyes; and hydroquinone-quinone. Preferred electrolytes among theses are metal iodides such as LiI, NaI, KI, CsI, and CaI₂, iodide salts of quaternary imidazolium compounds, iodide salts of quaternary pyridinium compounds, and iodide salts of tetraalkylammonium compounds. The electrolyte is preferably present in the gel electrolyte in a concentration of 0.05 to 1.5 mol/liter, more preferably 0.1 to 0.8 mol/liter. It is possible to preform an oxidation-reduction pair by adding iodine to the electrolyte. The concentration of iodine added is preferably 0.01 to 0.2 mol/liter because better results are obtained. A too lower electrolyte concentration would reduce the electron-carrier function whereas a too higher electrolyte concentration would contribute to little further improvement and increase the viscosity, leading to a drop of photocurrent density.

The solvent used in the gel electrolyte according to the invention is desirably a compound having a low viscosity and improving an ion mobility, or having a high dielectric constant and improving an effective carrier concentration so that good ionic conductivity is exerted. Such solvents are exemplified by carbonate compounds such as ethylene carbonate and propylene carbonate; heterocyclic compounds such as 3-methyl-2-oxazolidinone; ether compounds such as dioxane and diethyl ether; chain ethers such as ethylene glycol dialkyl ethers, propylene glycol dialkyl ethers, polyethylene glycol dialkyl ethers and polypropylene glycol dialkyl ethers; alcohols such as methanol, ethanol, ethylene glycol monoalkyl ethers, propylene glycol monoalkyl ethers, polyethylene glycol monoalkyl ethers, and polypropylene glycol monoalkyl ethers; polyhydric alcohols such as ethylene glycol, propylene glycol, polyethylene glycol, polypropylene glycol, and glycerin; nitrile compounds such as acetonitrile, glutarodinitrile, methoxyacetonitrile, propionitrile, and benzonitrile; aprotic polar compounds such as dimethyl sulfoxide and sulfolane; and water. Of these, carbonate compounds such as ethylene carbonate and propylene carbonate; heterocyclic compounds such as 3-methyl-2-oxazolidinone; and nitrile compounds such as acetonitrile, glutarodinitrile, methoxyacetonitrile, propionitrile, and benzonitrile are especially preferred.

In the practice of the invention, the electrolyte is preferably gelled by mixing a gelling agent, an electrolyte and a solvent, heating them for dissolution to form an isotropic solution, applying the solution onto a dye-carrying electrode as by casting, coating, dipping or impregnation, to thereby form a sol-like electrolyte layer on the electrode, and cooling the layer for gelation.

When the gel electrolyte layer is formed by coating, a uniform coating solution is first prepared by adding a coating modifier (e.g., a leveling agent) and other additives to the solution containing the gelling agent and electrolyte in solvent and heating the mixture for dissolution. The coating solution is applied by suitable techniques, such as spin coating, dip coating, air knife coating, curtain coating, roller coating, wire bar coating, gravure coating, extrusion coating using the hopper described in USP 2,681,294, and multi-layer co-coating as described in USP 2,761,418, 3,508,947 and 2,761,791. This is followed by cooling to form a gel electrolyte. The heating temperature may be determined as appropriate depending on the heat resistant temperature of the dye, and the like although an appropriate temperature is often 10 to 150°C. If desired, a compound in reduced state such as iodine is introduced into the gel electrolyte after its formation, for example, by a technique of placing a sample containing the gel electrolyte and the compound in reduced state such as iodine in a sealed container, and allowing the compound to diffuse into the gel electrolyte. The compound in reduced state such as iodine can also be incorporated into the device by coating or vapor depositing the compound to the counter electrode.

When the photoelectric conversion device constitutes a photo-electrochemical cell, the counter electrode serves as a positive electrode in the photo-electrochemical cell. The counter electrode is usually of the same definition as the conductive support described above. In the case of a strength-sustainable construction, the support is not always necessary. The provision of the support is advantageous from the sealing aspect.

In order that light reach the photosensitive layer, at least one of the conductive support and the counter electrode must be substantially transparent. The photo-regenerative photo-electrochemical cell of the invention favors the construction that the conductive support is transparent and sunlight is incident on the support side. Better results are obtained in this embodiment when the counter electrode has light reflecting property.

The counter electrode in the regenerative photo-electrochemical cell may be a glass or plastic member having a metal or conductive oxide evaporated thereon. Alternatively, a metal thin film may be formed by evaporation or sputtering to a thickness of up to 5 µm, preferably 5 nm to 3 µm. In one preferred embodiment, a glass member having platinum evaporated thereon or a metal thin film formed by evaporation or sputtering is used as the counter electrode.

The photosensitive layer is designed in accordance with the intended application and may have a single layer construction or a multilayer construction. The dye in one photosensitive layer may be a single dye or a mixture of dyes.

In the regenerative photo-electrochemical cell of the invention, the side of the cell may be sealed with a polymer or adhesive for preventing oxidative degradation of the components.

The thus obtained photo-electrochemical cell, as measured at AM 1.5G and 100 mW/cm², exhibits an open voltage of 0.01 to 3 volts, a short-circuit current density of 0.001 to 20 mA/cm², a fill factor of 0.1 to 0.99, and a conversion efficiency of 0.001 to 25%.

### EXAMPLE

Examples of the invention are given below for illustrating the preparation of a dye-sensitized photoelectric converter and a regenerative photo-electrochemical cell according to the invention, but the invention is not limited to these examples. Comparative Examples are given for ascertaining the benefits of the invention.

### Example 1

### 1. Preparation of titanium dioxide dispersion

A stainless steel vessel having an internal volume of 200 ml and lined on the inside surface with Teflon was charged with 15 g of titanium dioxide (Degussa P-25 by Nippon Aerosil K.K.), 45 g of water, 1 g of a dispersant (Triton X-100 by Aldrich), and 30 g of zirconia beads having a diameter of 0.5 mm (Nikkato K.K.). Using a sand grinder mill (Imex K.K.), the contents were dispersed at 1,500 rpm for 2 hours. The zirconia beads were removed from the dispersion by filtration. The titanium dioxide had a mean particle size of 2.5 µm as measured by Master Sizer of MALVERN.

### 2. Preparation of dye-adsorbed TiO₂ electrode (Electrode A)

On the conductive surface side of a conductive glass piece coated with fluorine-doped tin oxide (TCO Glass U by Asahi Glass K.K. cut to 20 mm x 20 mm), the dispersion prepared above was applied using a glass bar. More particularly, eight glass pieces were closely arranged in two columns (2x4) with the conductive surface side faced upward. Adhesive tape strips were attached to opposite end portions (3 mm from the end) of the two columns of glass pieces. The dispersion was applied to the set of eight glass pieces between the tape strips and spread thereon by sliding a glass bar on the parallel tape strips which serve as a spacer and mask. After application, the adhesive tape strips were peeled off, and the coating was air dried for one day at room temperature. The end portions where the adhesive tape strips had been attached were later used to provide electrical connection with a tester for the measurement of photocurrent. Next, the glass pieces were placed in an electric furnace (muffle furnace Model FP-32 by Yamato Science K.K.) where they were fired at 450°C for 30 minutes. The glass pieces were taken out and cooled down whereupon they were immersed for 3 hours in an ethanol solution containing 3x10⁻⁴ mol/l of a dye as shown in Table 2. The dye-adsorbed glass pieces were immersed in 4-tert-butylpyridine for 15 minutes, washed with ethanol and air dried. The thus obtained photosensitive layer was 10 µm thick, and the coverage of semiconductor nanoparticulates was 20 g/m². The coverage of the dye was selected as appropriate in the range of 0.1 to 10 mmol/m², depending on the particular type of dye used.

It is noted that the conductive glass had a surface resistivity of about 30 Ω/cm².

### 3. Fabrication of photo-regenerative photo-electrochemical cell comprising gel electrolyte

Each of the compositions shown in Table 2 was heated at 80°C for one hour to form an isotropic solution. After a counter electrode having platinum deposited thereon was rested on a dye-carrying TiO₂ electrode, the solution was introduced into this assembly under the impetus of an osmotic pressure. The assembly was then cooled to room temperature for converting the electrolyte layer into a gel, obtaining a photo-regenerative photo-electrochemical cell.

Cells were also fabricated by repeating the above steps while changing the combination of the dye with the electrolyte composition as shown in Table 2.

The cells fabricated in this example are photo-electrochemical cells in which a conductive glass 1 (glass having a conductive layer 2), a TiO₂ electrode 3, a dye layer 4, a gel electrolyte layer 5, a platinum layer (or counter electrode) 6, and a glass plate 7 are stacked in the described order as shown in FIG. 1.

**Table 2**

| No. | Dye | Oil Gelling agent | Gel electrolyte concentration (g/l) | Supporting electrolyte | Electrolyte concentration (mol/l) | Solvent (volume ratio) |
|---|---|---|---|---|---|---|
| 1 | R-1 | O-2 | 32 | LiI | 0.3 | NMO |
| 2 | (5) | O-5 | 45 | LiI | 0.6 | PC/NMO=1/1 |
| 3 | (8) | O-9 | 26 | LiI | 0.3 | NMO/DME=1/1 |
| 4 | (11) | O-11 | 70 | LiI | 0.4 | NMO/EC=1/1 |
| 5 | R-1 | O-15 | 46 | LiI | 0.6 | AN/NMO=7/3 |
| 6 | R-1 | O-15 | 24 | (C₃H₇)₄NI | 0.5 | AN/NMO=8/2 |
| 7 | R-5 | O-16 | 15 | LiI | 0.5 | AN/NMO=8/2 |
| 8 | (14) | O-17 | 20 | (C₃H₇)₄NI | 0.5 | AN/NMO=9/1 |
| 9 | (82) | O-21 | 18 | LiI | 0.5 | AN/NMO=8/2 |
| 10 | R-1 | O-24 | 30 | LiI | 0.5 | AN/NMO=9/1 |
| 11 | R-5 | O-15 | 23 | MHIm | 0.5 | AN/NMO=8/2 |
| 12 | R-1 | O-17 | 44 | LiI | 0.7 | NMO |
| 13 | (87) | O-16 | 20 | LiI | 0.5 | AN/NMO=8/2 |
| 14 | (R-6) | O-28 | 22 | (C₃H₇)₄NI | 0.5 | NMO/EC=1/1 |
| 15 | R-9 | O-29 | 30 | LiI | 0.5 | AN/NMO=9/1 |
| 16 | (90) | O-16 | 32 | LiI | 0.5 | AN/NMO=8/2 |
| 17 | (93) | O-28 | 24 | LiI | 0.1 | PC/NMO=1/1 |
| 18 | (104) | O-15 | 25 | KI | 0.5 | AN/NMO=9/1 |
| 19 | (105) | O-16 | 20 | LiI | 0.5 | NMO |
| 20 | (106) | O-29 | 26 | LiI | 0.5 | AN/NMO=8/2 |
| 21 | (107) | O-31 | 30 | MHIm | 0.8 | AN/NMO=9/1 |
| 22 | (110) | O-16 | 20 | LiI | 0.5 | AN/NMO=8/2 |
| 23 | (132) | O-15 | 22 | (C₃H₇)₄NI | 0.5 | AN/NMO=8/2 |
| 24 | (10) | O-32 | 24 | (C₃H₇)₄NI | 0.5 | AN/NMO=8/2 |
| 25 | (13) | O-33 | 31 | LiI | 0.5 | AN/NMO=8/2 |
| 26 | R-1 | O-28 | 20 | LiI | 0.5 | PC/DME=1/1 |
| 27 | (34) | O-16 | 24 | LiI | 0.7 | AN/NMO=8/2 |
| 28 | R-1 | O-29 | 20 | (C₃H₇)₄NI | 0.5 | AN/NMO=9/1 |
| 29 | R-5 | O-28 | 28 | LiI | 0.5 | AN/NMO=8/2 |
| 30 | R-1 | O-29 | 34 | LiI | 0.5 | NMO |
| Note: NMO: 3-methyl-2-oxazolidinone PC: propylene carbonate EC: ethylene carbonate DME: dimethoxyethane AN: acetonitrile MHIm: iodide salt of 1-methyl-3-hexylimidazolium | | | | | | |

### 4. Measurement of photoelectric conversion efficiency

Light of a 500-W xenon lamp (Ushio K.K.) was passed through a AM 1.5 filter (by Oriel Co.) and a sharp cut filter Kenko L-42, obtaining simulated sunlight free of ultraviolet radiation. The intensity of light was 86 mW/cm².

With clips connected to the conductive glass substrate and the platinum-deposited glass member of the photoelectric converter, the simulated sunlight was irradiated to the cell. The electricity generated in the cell was measured by a current-voltage tester (Keithley SMU238). The open circuit voltage (Voc), short-circuit current density (Jsc), fill factor (FF), and conversion efficiency (η) of this solar battery were reported in Table 3 along with the short-circuit current density after 120 hours of continuous irradiation and a percent drop thereof. Note that the percent drop of short-circuit current density is calculated according to [1 - (Jsc after 120 hr.)/(initial Jsc)]x100.

### Comparative Example 1

On the dye-sensitized TiO₂ electrode substrate (Electrode A, 20 mm x 20 mm) prepared in Example 1 was rested a platinum-deposited glass member of the same size (see FIG. 1). By utilizing a capillary phenomenon, an electrolytic solution was penetrated into the interface or space between the glass plates. The electrolytic solution contained 0.05 mol/l of iodine and 0.5 mol/l of lithium iodide in a mixture of acetonitrile and 3-methyl-2-oxazolidinone in a volume ratio of 90:10. A comparative photo-electrochemical battery A was fabricated in this way.

### Comparative Example 2

A mix solution was prepared by mixing 1 g of hexaethylene glycol methacrylate (Blenmer PE350 by Nippon Oil & Fats K.K.), 1 g of ethylene glycol, and 20 mg of 2-hydroxy-2-methyl-1-phenyl-propan-1-one (Darocure 1173 by Nippon Ciba Geigy K.K.) as a polymerization initiator, dissolving 500 mg of lithium iodide in the solution, and deaerating in vacuum for 10 minutes. This mix solution was applied onto the dye-sensitized TiO₂ electrode substrate (Electrode A, 20 mm x 20 mm) prepared in Example 1. The porous material having the mix solution coated thereon was placed in vacuum for removing bubbles from the porous material and helping the monomer penetrate. Thereafter, ultraviolet radiation was irradiated to effect polymerization, thereby distributing a uniform gel of polymer in pores of the porous material. The thus obtained material was exposed to an iodine atmosphere for 30 minutes whereby iodine was diffused into the polymer. A comparative photo-electrochemical battery B was fabricated in this way.

These comparative batteries A and B were tested as in Example 1. The results are also shown in Table 3.

**Table 3**

| No. | J_{sc} (mA/cm²) | V_{oc} (V) | FF | η (%) | J_{sc} after 120 hr. (mA/cm²) | J_{sc} drop (%) |
|---|---|---|---|---|---|---|
| 1 | 8.9 | 0.60 | 0.46 | 2.86 | 7.6 | 15 |
| 2 | 2.6 | 0.65 | 0.60 | 1.18 | 2.3 | 13 |
| 3 | 2.8 | 0.70 | 0.54 | 1.23 | 2.3 | 18 |
| 4 | 2.6 | 0.62 | 0.62 | 1.16 | 2.4 | 8 |
| 5 | 10.1 | 0.75 | 0.48 | 4.23 | 9.5 | 6 |
| 6 | 9.8 | 0.72 | 0.46 | 3.77 | 9.5 | 3 |
| 7 | 10.5 | 0.68 | 0.59 | 4.90 | 8.8 | 16 |
| 8 | 2.6 | 0.64 | 0.53 | 1.03 | 2.2 | 15 |
| 9 | 3.3 | 0.68 | 0.50 | 1.30 | 2.7 | 17 |
| 10 | 8.6 | 0.62 | 0.49 | 3.04 | 7.2 | 16 |
| 11 | 11.2 | 0.58 | 0.61 | 4.61 | 9.9 | 12 |
| 12 | 8.3 | 0.66 | 0.60 | 3.82 | 6.8 | 18 |
| 13 | 3.4 | 0.53 | 0.58 | 1.22 | 2.9 | 16 |
| 14 | 2.3 | 0.70 | 0.55 | 1.03 | 2.0 | 15 |
| 15 | 7.8 | 0.69 | 0.56 | 3.50 | 6.7 | 14 |
| 16 | 8.6 | 0.63 | 0.57 | 3.59 | 7.1 | 18 |
| 17 | 9.2 | 0.69 | 0.52 | 3.84 | 8.6 | 6 |
| 18 | 4.6 | 0.70 | 0.56 | 2.10 | 4.0 | 14 |
| 19 | 4.2 | 0.72 | 0.50 | 1.76 | 3.5 | 16 |
| 20 | 3.8 | 0.63 | 0.48 | 1.34 | 3.2 | 17 |
| 21 | 4.1 | 0.68 | 0.50 | 1.62 | 3.5 | 15 |
| 22 | 2.4 | 0.69 | 0.58 | 1.12 | 2.2 | 9 |
| 23 | 2.9 | 0.72 | 0.54 | 1.31 | 2.6 | 11 |
| 24 | 2.7 | 0.62 | 0.53 | 1.03 | 2.1 | 23 |
| 25 | 2.8 | 0.63 | 0.54 | 1.11 | 2.3 | 19 |
| 26 | 8.5 | 0.70 | 0.56 | 3.87 | 7.1 | 16 |
| 27 | 2.9 | 0.60 | 0.52 | 1.05 | 2.5 | 13 |
| 28 | 7.4 | 0.68 | 0.59 | 3.45 | 6.5 | 12 |
| 29 | 10.6 | 0.70 | 0.56 | 4.83 | 9.4 | 11 |
| 30 | 9.6 | 0.68 | 0.51 | 3.87 | 7.9 | 18 |
| Comparative solar battery A | 9.9 | 0.60 | 0.43 | 2.97 | 2.2 | 78 |
| Comparative solar battery B | 1.53 | 0.35 | 0.50 | 0.31 | 1.0 | 34 |

As compared with Comparative photo-electrochemical battery A, the batteries in Example 1 experience little deterioration of photoelectric conversion properties. As compared with Comparative photo-electrochemical battery B, the batteries in Example 1 produce a high short-circuit current density and superior photoelectric conversion properties.

The invention provides a photoelectric conversion device which has improved photoelectric conversion properties and minimized deterioration with time of such properties.

Reasonable modifications and variations are possible from the foregoing disclosure without departing from the scope of the present invention as defined by the claims.

## Claims

1. A photoelectric conversion device comprising a conductive support (1, 2), a layer (3) coated on the conductive support and containing semiconductor nanoparticulates having a dye (4) adsorbed thereto, a gel electrolyte-containing layer (5), and a counter electrode (6),
wherein said gel electrolyte contains an electrolyte, an organic solvent, and a gelling agent having a molecular weight of up to 1,000 by which gelling of said gel electrolyte is caused.

2. The photoelectric conversion device of claim 1 wherein said electrolyte comprises at least one member selected from the group consisting of metal iodides, iodide salts of quaternary ammonium compounds, iodide salts of quaternary imidazolium compounds, iodide salts of quaternary pyridinium compounds, metal bromides, bromide salts of quaternary ammonium compounds, sulfur compounds, viologen dyes, and hydroquinone-quinone.

3. The photoelectric conversion device of claim 1 wherein said electrolyte is present in a concentration of 0.05 to 1.5 mol/liter of said gel electrolyte.

4. The photoelectric conversion device of claim 2 wherein said electrolyte contains iodine.

5. The photoelectric conversion device of claim 1 wherein said gelling agent is present in a concentration of 0.2 to 500 g/liter of said gel electrolyte.

6. The photoelectric conversion device of claim 1 wherein said organic solvent is selected from the group consisting of nitrile compounds, carbonate compounds, nitrogenous heterocyclic compounds, and ethylene glycol dialkyl ethers.

7. The photoelectric conversion device of claim 1 wherein said dye is a ruthenium complex dye or polymethine dye.

8. A photo-electrochemical cell comprising the photoelectric conversion device of any one of claims 1 to 7.

## Patentansprüche

1. Fotoelektrische Umwandlungsvorrichtung umfassend' einen leitfähigen Träger (1, 2), eine Schicht (3), die über den leitfähigen Träger gezogen ist und enthaltend Halbleiter-Nanopartikel mit einem Farbstoff (4), der darauf adsorbiert ist, eine Gelelektrolyt-enthaltende Schicht (5) und eine Gegenelektrode (6), wobei der genannte Gelelektrolyt ein Elektrolyt, ein organisches Lösungsmittel und ein Geliermittel mit einem Molekulargewicht von bis zu 1.000 enthält, wo die Gelierung des genannten Gelelektrolyts hervorgerufen wird.

2. Fotoelektrische Umwandlungsvorrichtung nach Anspruch 1, wobei der genannte Elektrolyt mindestens einen Bestandteil ausgewählt aus der Gruppe bestehend aus Metalljodiden, Jodidsalzen quartärer Ammoniumverbindungen, Jodidsalze quartärer Imidazoliumverbindungen, Jodidsalze quartärer Pyridiniumverbindungen, Metallbromide, Bromidsalze quartärer Ammoniumverbindungen, Schwefelverbindungen, Viologenfarbstoffe und Hydrochinon-Chinon enthält.

3. Fotoelektrische Umwandlungsvorrichtung nach Anspruch 1, wobei der genannte Elektrolyt in einer Konzentration von 0,05 bis 1,5 mol/Liter des genannten Gelelektrolyts vorliegt.

4. Fotoelektrische Umwandlungsvorrichtung nach Anspruch 2, wobei der genannte Elektrolyt Jodid enthält.

5. Fotoelektrische Umwandlungsvorrichtung nach Anspruch 1, wobei das genannte Geliermittel in einer Konzentration von 0,2 bis 500 g/Liter des genannten Gelelektrolyts vorliegt.

6. Fotoelektrische Umwandlungsvorrichtung nach Anspruch 1, wobei das genannte organische Lösungsmittel aus der Gruppe bestehend aus Nitrilverbindungen, Carbonatverbindungen, heterocyclischen Stickstoffverbindungen und Ethylenglykol-Dialkyletern ausgewählt ist.

7. Fotoelektrische Umwandlungsvorrichtung nach Anspruch 1, wobei der genannte Farbstoff ein Rutheniumkomplex-Farbstoff oder ein Polymethin-Farbstoff ist.

8. Fotoelektrochemische Zelle umfassend die fotoelektrische Umwandlungsvorrichtung nach einem oder mehreren der Ansprüche 1 bis 7.

## Revendications

1. Dispositif de conversion photoélectrique comprenant un support conducteur (1, 2), une couche (3) déposée sur le support conducteur et contenant des nanoparticules semiconductrices ayant adsorbé un colorant (4), une couche (5) contenant un électrolyte du type gel, et une contre-électrode (6),
où ledit électrolyte du type gel contient un électrolyte, un solvant organique, et un agent gélifiant dont le poids moléculaire peut aller jusqu'à 1 000, par lequel est provoquée la gélification dudit électrolyte de type gel.

2. Dispositif de conversion photoélectrique selon la revendication 1, où ledit électrolyte comprend au moins un élément choisi dans le groupe comprenant les iodures de métal, les sels du type iodure de composés d'ammonium quaternaire, des sels du type iodure de composés d'imidazolium quaternaire, des sels du type iodure de composés de pyridinium quaternaire, des bromures de métal, des sels du type bromure de composés d'ammonium quaternaire, des composés à base de soufre, des colorants du type viologène, et de l'hydroquinone-quinone.

3. Dispositif de conversion photoélectrique selon la revendication 1, où ledit électrolyte est présent à une concentration de 0,05 à 1,5 mol par litre dudit électrolyte de type gel.

4. Dispositif de conversion photoélectrique selon la revendication 2, où ledit électrolyte contient de l'iode.

5. Dispositif de conversion photoélectrique selon la revendication 1, où ledit agent gélifiant est présent à une concentration de 0,2 à 500 g/l dudit électrolyte de type gel.

6. Dispositif de conversion photoélectrique selon la revendication 1, où ledit solvant organique est choisi dans le groupe comprenant des composés du type nitrile, des composés du type carbonate, des composés hétérocycliques azotés, des éthylèneglycoldialkyléthers.

7. Dispositif de conversion photoélectrique selon la revendication 1, où ledit colorant est un colorant complexe de ruthénium ou un colorant du type polyméthine.

8. Cellule électrophotochimique comprenant le dispositif de conversion photoélectrique tel que défini dans l'une quelconque des revendications 1 à 7.
